# EUROPEAN PATENT APPLICATION

(11) **EP 4 576 983 A1**
(43) Date of publication of application: **25.06.2025**
(21) Application number: 24808526.8
(22) Date of filing: 19.09.2024
(51) Int. Cl.: H10B 80/00

(54) **MEMORY CHIP, LOGIC CHIP, CHIP STACKING STRUCTURE AND MEMORY**

(30) Priority: 16.10.2023 CN 202311343408
(71) Applicant: CXMT Corporation, Hefei, Anhui 230601 (CN)
(72) Inventor: ZHANG, Jiarui, Hefei, Anhui 230601 (CN)
(74) Representative: Gulde & Partner
(86) International application number: PCT/CN2024/119830
(87) International publication number: WO 2025/082129

(57) **Abstract**

The present disclosure provides a memory chip, a logic chip, a chip stack structure, and a memory. **In** the memory chip, four first transmission structures are arranged symmetrically about a first axis and a second axis; four second transmission structures in each second transmission structure group are arranged symmetrically about the first axis and the second axis; the memory chip receives one first identification signal from each one of the first transmission structures and generates a chip position identification code based on four first identification signals; the memory chip receives one second identification signal from each second transmission structure group and generates a stack position identification code based on B second identification signals.

## Description

### CROSS-REFERENCE TO RELATED APPLICATIONS

The present disclosure claims priority to Chinese Patent Application No. 202311343408.4 filed with China National Intellectual Property Administration on October 16, 2023 and entitled "MEMORY CHIP, LOGIC CHIP, CHIP STACK STRUCTURE, AND MEMORY", the content of which is incorporated herein by reference in its entirety.

### TECHNICAL FIELD

The present disclosure relates to the field of semiconductors, and in particular, to a memory chip, a logic chip, a chip stack structure, and a memory.

### BACKGROUND

With the development of integrated circuit technologies, remarkable progress has been made in the manufacturing process of semiconductor devices. In recent years, however, the development of two-dimensional semiconductor technology has been accompanied by various challenges, including physical limits, limits of existing development technology, limits of storage electron density, etc. In this context, to solve the difficulties encountered by two-dimensional semiconductor devices and to pursue lower production costs per unit memory cell, a plurality of chips may be stacked by using a bonding process (e.g., hybrid bonding, bumping, and wire bonding) to form a three-dimensional semiconductor device. However, for the three-dimensional semiconductor device, connection structures between different chips still have problems such as large parasitic capacitance and large parasitic resistance, which affect the signal transmission quality.

### SUMMARY

The present disclosure provides a memory chip, a logic chip, a chip stack structure, and a memory. The technical solutions of the present disclosure are realized as follows.

In a first aspect, an embodiment of the present disclosure provides a memory chip, where a top surface of the memory chip has a first axis and a second axis, the first axis and the second axis are perpendicular to each other and intersect at a center of the top surface, the first axis is parallel to one edge of the top surface, and the second axis is parallel to the other edge of the top surface; the memory chip includes four first transmission structures and B second transmission structure groups, where B is a natural number; the four first transmission structures are arranged symmetrically about the first axis, and the four first transmission structures are arranged symmetrically about the second axis; each one of the second transmission structure groups includes four second transmission structures, and the four second transmission structures are arranged symmetrically about the first axis and the four second transmission structures are arranged symmetrically about the second axis; the memory chip receives one first identification signal from each one of the first transmission structures and generates a chip position identification code based on four first identification signals; signal levels transmitted by the four second transmission structures in a same one of the second transmission structure groups are the same, and the memory chip receives one second identification signal from each one of the second transmission structure groups and generates a stack position identification code based on B second identification signals; where the memory chip determines a position number thereof in a chip stack structure to which the memory chip belongs according to the stack position identification code and the chip position identification code.

In a second aspect, an embodiment of the present disclosure provides a logic chip, where a top surface of the logic chip has a first axis and a second axis, the first axis and the second axis are perpendicular to each other and intersect at a center of the top surface, the first axis is parallel to one edge of the top surface, and the second axis is parallel to the other edge of the top surface; the logic chip includes four third transmission structures and B fourth transmission structure groups, where B is a natural number; the four third transmission structures are arranged symmetrically about the first axis and the four third transmission structures are arranged symmetrically about the second axis; each one of the fourth transmission structure groups includes four fourth transmission structures, and the four fourth transmission structures are arranged symmetrically about the first axis and the four fourth transmission structures are arranged symmetrically about the second axis; the logic chip is configured to generate four first identification signals and transmit the four first identification signals to the four third transmission structures in a one-to-one correspondence, where the four first identification signals indicate a chip position identification code of a memory chip adjacent to the logic chip; the logic chip is further configured to receive one second identification signal from each one of the fourth transmission structure groups and generate a stack position identification code based on B second identification signals in an initialization process; or generate B second identification signals of a default state and send one of the second identification signals to one of the fourth transmission structure groups in a normal operation stage.

In a third aspect, an embodiment of the present disclosure provides a chip stack structure. The chip stack structure includes the logic chip as described in the second aspect and at least one stack unit, and the logic chip and the at least one stack unit are sequentially stacked along a third direction; each one of the at least one stack unit includes a first memory chip, a second memory chip, a third memory chip, and a fourth memory chip sequentially stacked along the third direction, and the third direction is perpendicular to a top surface of each one of the memory chips; the first memory chip, the second memory chip, the third memory chip and the fourth memory chip are each the memory chip as described in the first aspect;
the first memory chip and the second memory chip are stacked in a face-to-face manner, the second memory chip and the third memory chip are stacked in a back-to-back manner, and the third memory chip and the fourth memory chip are stacked in a face-to-face manner;
the logic chip and the first memory chip are stacked in a back-to-back manner; or the logic chip and the first memory chip are stacked in a face-to-back manner. In a fourth aspect, an embodiment of the present disclosure provides a memory. The memory includes the chip stack structure as described in the third aspect.

Embodiments of the present disclosure provide a memory chip, a logic chip, a chip stack structure, and a memory. The number of driving circuits and data selectors is reduced and thereby the parasitic capacitance is reduced; in addition, a face-to-face (F2F) chip stack structure formed by the memory chips realizes a rotation-type transmission of signals via direct connection configuration of the vias and reduces the parasitic resistance; meanwhile, for the above chip stack structure, the chip position identification code and the stack position identification code are transmitted by using a small number of transmission structures, and the chip stack structure has good transmission accuracy and the chip area can be effectively reduced.

### BRIEF DESCRIPTION OF THE DRAWINGS

FIG. 1 is a schematic structural diagram of a chip;
FIG. 2A is a schematic diagram of signal transmission in a chip stack structure;
FIG. 2B is a schematic diagram of signal transmission in another chip stack structure;
FIG. 3 is a first schematic structural diagram of a memory chip provided according to an embodiment of the present disclosure;
FIG. 4 is a second schematic structural diagram of a memory chip provided according to an embodiment of the present disclosure;
FIG. 5 is a third schematic structural diagram of a memory chip provided according to an embodiment of the present disclosure;
FIG. 6 is a schematic diagram of a second transmission structure provided according to an embodiment of the present disclosure;
FIG. 7A is a schematic diagram showing a working scenario of a memory chip provided according to an embodiment of the present disclosure;
FIG. 7B is a schematic diagram showing a working scenario of another memory chip provided according to an embodiment of the present disclosure;
FIG. 8 is a schematic structural diagram of a logic operation circuit provided according to an embodiment of the present disclosure;
FIG. 9 is a fourth schematic structural diagram of a memory chip provided according to an embodiment of the present disclosure;
FIG. 10 is a first schematic structural diagram of a logic chip provided according to an embodiment of the present disclosure;
FIG. 11 is a second schematic structural diagram of a logic chip provided according to an embodiment of the present disclosure;
FIG. 12 is a third schematic structural diagram of a logic chip provided according to an embodiment of the present disclosure;
FIG. 13 is a first schematic diagram of a chip stack structure provided according to an embodiment of the present disclosure;
FIG. 14A is a first schematic diagram of signal transmission in a chip stack structure provided according to an embodiment of the present disclosure;
FIG. 14B is a second schematic diagram of signal transmission in a chip stack structure provided according to an embodiment of the present disclosure;
FIG. 15A is a first schematic diagram of signal transmission in another chip stack structure provided according to an embodiment of the present disclosure;
FIG. 15B is a second schematic diagram of signal transmission in another chip stack structure provided according to an embodiment of the present disclosure;
FIG. 16A is a first schematic diagram of signal transmission in a yet another chip stack structure provided according to an embodiment of the present disclosure;
FIG. 16B is a second schematic diagram of signal transmission in yet another chip stack structure provided according to the embodiment of the present disclosure;
FIG. 17A is a first schematic diagram of signal transmission in still another chip stack structure provided according to an embodiment of the present disclosure;
FIG. 17B is a second schematic diagram of signal transmission in a still another chip stack structure provided according to an embodiment of the present disclosure;
FIG. 18 is a schematic structural diagram of a memory provided according to an embodiment of the present disclosure.

### DETAILED DESCRIPTION

The technical solutions in the embodiments of the present disclosure will be clearly and completely described below with reference to the drawings in the embodiments of the present disclosure. It can be understood that the specific embodiments described herein are merely illustrative of a related application and are not intended to limit the application. In addition, it should be noted that for the convenience of description, only the portions relevant to the related applications are shown in the drawings. Unless defined otherwise, all technical and scientific terms used herein have the same meaning as commonly understood by those skilled in the art to which the present disclosure belongs. The terms used herein are for the purpose of describing the embodiments of the present disclosure only and are not intended to limit the present disclosure. In the following description, reference is made to "some embodiments" which describe a subset of all possible embodiments, but it can be understood that "some embodiments" may be the same subset or different subsets of all possible embodiments and may be combined with each other without conflict. It should be noted that the terms "first\second\third" referred to in the embodiments of the present disclosure are merely used for distinguishing similar objects and do not represent a specific ordering for the objects. It can be understood that "first\second\third" may be subjected to interchange of a specific order or sequence if permitted, such that the embodiments of the present disclosure described herein can be implemented in an order other than that shown or described.
Dynamic random access memory (DRAM);
Synchronous dynamic random access memory (SDRAM);
Double data rate SDRAM (DDR);
Low power DDR (LPDDR).

Before describing the embodiments of the present disclosure, three directions for describing three-dimensional structures that may be used in the planes involved in the following embodiments are defined. Taking the Cartesian coordinate system as an example, the three directions may include a first direction, a second direction, and a third direction.

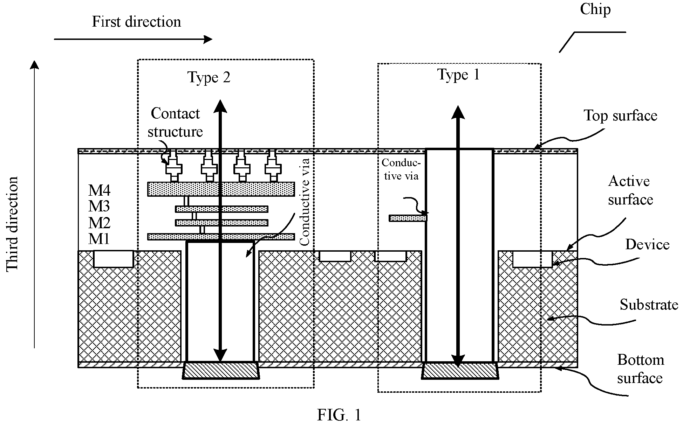

Referring to FIG. 1, a semiconductor chip (specifically, a memory chip or a logic chip) may include a top surface at a front side and a bottom surface at a back side opposite to the front side. A direction intersecting with (e.g., perpendicular to) the top surface and the bottom surface of the semiconductor chip is defined as a third direction in the case that the flatness of the top surface and the bottom surface is ignored. On the top surface of the semiconductor chip, two directions perpendicular to each other, i.e., a first direction and a second direction, are defined, and the first direction is perpendicular to one edge of the semiconductor chip, and the second direction is perpendicular to another edge of the semiconductor chip.

Referring to FIG. 1, the semiconductor chip includes a substrate, an active surface is formed at a side of the substrate for manufacturing devices (e.g., transistors and capacitors), and a plurality of metal layers, for example, M1, M2, M3, ..., are distributed between the substrate and the top surface. FIG. 1 further shows two types of transmission structures, both of which are used for signal connection between different stacked chips.

As shown in FIG. 1, the type 1 transmission structure includes conductive vias extending along a third direction. The conductive vias penetrate through the bottom surface and the top surface at least along the third direction, and the conductive vias are connected to an internal circuit of the chip via the metal layers.

As shown in FIG. 1, the type 2 transmission structure includes contact structures and conductive vias spaced apart along the third direction. The conductive vias penetrate through the substrate along the third direction, and the contact structures penetrate through the top surface along the third direction; the contact structures and the conductive vias are not directly electrically connected, but are indirectly electrically connected by the metal layers. For example, in FIG. 1, the contact structures are connected to the metal layer M4, and the conductive vias are connected to the metal layer M1, thus achieving electrical connection. Of course, in other embodiments, the contact structure and the conductive via may be designed to be electrically connected directly.

Meanwhile, the types of the transmission structures are not limited to the above two types, and a structure capable of achieving electrical connection among different stacked chips may be considered as the transmission structure.

In particular, the illustrations presented in the present disclosure are not meant to be actual views of any particular microelectronic apparatus or components thereof, but are merely idealized representations for describing illustrative embodiments. The drawings are not necessarily to scale. The embodiments of the present disclosure are described in detail below with reference to the drawings.

In an embodiment, a memory chip and a logic chip are provided. The memory chip/the logic chip includes a plurality of transmission structures penetrating through the chip along a third direction, and the transmission structures are used to implement signal transmission among different chips. Illustratively, the transmission structure may be a conductive via (e.g., a through silicon via). All the transmission structures may be located at any positions. In particular, every four transmission structures can be regarded as a transmission structure group in function, but the respective positions of the four transmission structures are not limited.

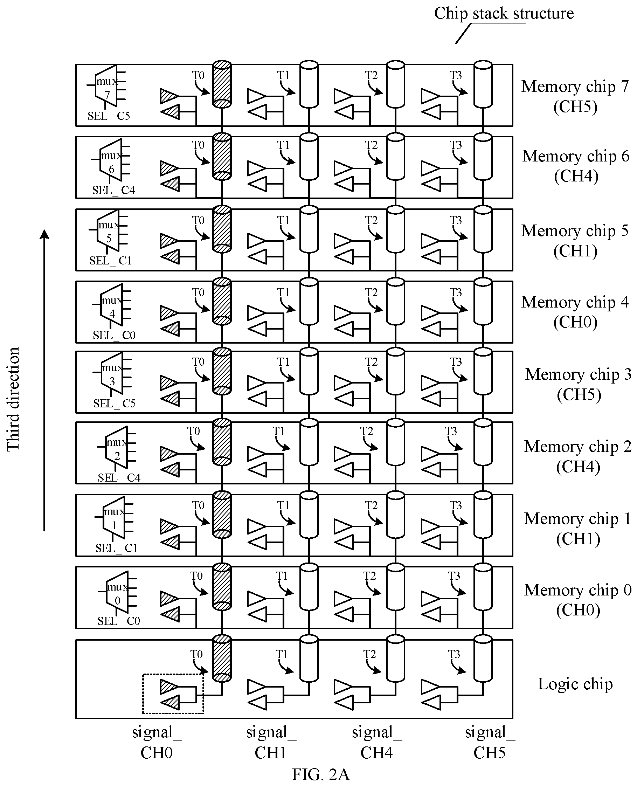

In a specific embodiment, eight memory chips and one logic chip are stacked in a face-to-back manner to form a 3D memory device, and the respective transmission structures of the eight memory chips are aligned along the third direction, and nine transmission structures aligned along the third direction are connected to form an electrical path. Referring to FIG. 2A, a schematic diagram of signal transmission in a chip stack structure is shown. As shown in FIG. 2A, the chip stack structure includes memory chips 0-7 and a logic chip, and FIG. 2A only shows four transmission structures T0-T3 for each memory chip, and the four transmission structures T0-T3 belong to the same transmission structure group. In this case, the transmission structures T0 in eight memory chips and one logic chip are all aligned to form one electrical path, and the transmission structures T1 in eight memory chips and one logic chip are all aligned to form one electrical path, ... ..., and so on. Meanwhile, each memory chip and the logic chip are further provided with a plurality of driving circuits (only one driving circuit is shown in a dashed box in FIG. 2A, and the other driving circuits are not shown), and each transmission structure is connected to one driving circuit. Each memory chip is further provided with a plurality of data selectors (e.g., mux0-7 in FIG. 2A), and each transmission structure group corresponds to one data selector, that is, all the transmission structures of one transmission structure group are connected to a data port of a data selector through respective driving circuits. That is, the data selector may decide the signal transmitted by which transmission structure is to be output to the inside of the memory chip or the signal output by the memory chip is output to which transmission structure.

For the whole memory device, the eight memory chips are divided into four channels (CH0, CH1, CH4, CH5) for management, and the signal Signal _CH0 of the channel CH0 is transmitted through an electrical path formed by "the transmission structure T0 in logic chip-the transmission structure T0 in the memory chip 0-the transmission structure T0 in the memory chip 1-the transmission structure T0 in the memory chip 2-the transmission structure T0 in the memory chip 3-the transmission structure T0 in the memory chip 4-the transmission structure T0 in the memory chip 5-the transmission structure T0 in the memory chip 6-the transmission structure T0 in the memory chip 7", while the select signals of the data selector mux0 in the memory chip 0 and the data selector mux4 in the memory chip 4 are both SEL_C0, i.e., the signal Signal_CH0 can enter the memory chip 0 and the memory chip 4 via the aforementioned electrical path; the process of signal output can be similarly understood.

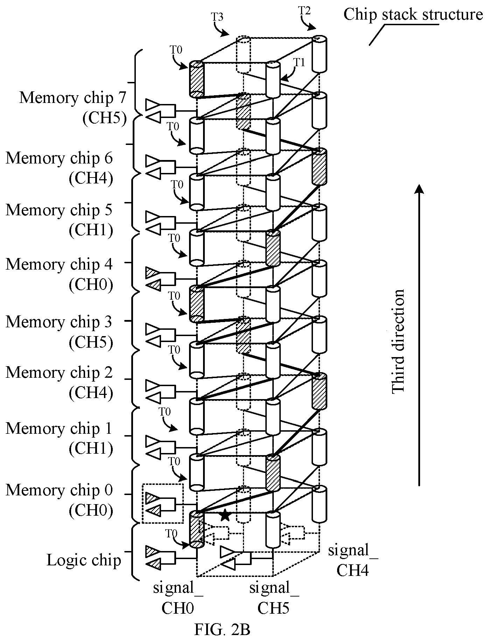

As can be seen from the above, the memory chip 0 only needs to acquire signals from the transmission structure T0, and the memory chip 1 only needs to acquire signals from the transmission structure T1, ..., that is, each memory chip only needs to acquire signals from one transmission structure in one transmission structure group. It is worth noting that different memory chips may need to acquire signals from different transmission structures. However, since all memory chips need to be designed to have the same structure during the manufacturing process (which can save cost and labor to the maximum), all transmission structures in the memory chips need to be designed with corresponding driving structures and data selectors for structural consistency. Further, in the case that the chip stack structure shown in FIG. 1 is adopted, each transmission structure corresponds to a driving circuit. In the working process of the chip stack structure, all driving circuits in all memory chips in the same channel need to be driven, resulting in a large load and large parasitic capacitance, which seriously affects the performance of the chips, restricts the transmission efficiency, increases the power consumption, and restricts the number of stacked chips in the three-dimensional device. In another embodiment, referring to FIG. 2B, a schematic diagram of signal transmission in another chip stack structure is shown. In particular, in FIG. 2B, only some of the transmission structures (T0-T3) are identified, and others are omitted, but for FIG. 2B, the identifiers of the transmission structures aligned along the third direction are the same. As shown in FIG. 2B, the chip stack structure also includes eight memory chips and one logic chip aligned along the third direction, but each transmission structure in each memory chip is connected to another transmission structure at a different position in another memory chip in a rotating manner, such that a general spiral-up connection is realized, i.e., the signal Signal_CH0 of the channel CH0 is transmitted through "the transmission structure T0 in the logic chip-the transmission structure T1 in the memory chip 0-the transmission structure T2 in the memory chip 1-the transmission structure T3 in the memory chip 2-the transmission structure T0 in the memory chip 3-the transmission structure T1 in the memory chip 4-the transmission structure T2 in the memory chip 5-the transmission structure T3 in the memory chip 6-the transmission structure T0 in the memory chip 7", and other signals are similarly transmitted.

In this way, the memory chip 0 can acquire the signal Signal_CH0 through the output end of the transmission structure T0 in the logic chip, the memory chip 1 can acquire the signal Signal_CH1 through the input end of the transmission structure T0 in the memory chip 0, the memory chip 2 can acquire the signal Signal _CH4 through the input end of the transmission structure T0 in the memory chip 1, and the memory chip 3 can acquire the signal Signal_CH5 through the input end of the transmission structure T0 in the memory chip 2, ..., such that for each memory chip, only one transmission structure in each transmission structure group needs to be connected to the driving circuit, and no data selector is needed, such that the number of devices can be reduced, thereby reducing the parasitic capacitance. However, compared with the direct connection configuration of transmission structures in FIG. 2A, the process of the rotational connection of the transmission structures in FIG. 2B is more complicated. Specifically, in FIG. 2B, a horizontal interconnection structure needs to be disposed between adjacent transmission structures in each memory chip (only one horizontal interconnection structure is marked with a five-pointed star in FIG. 2B), and the signal interconnection structures may be metal interconnection lines, transmission structures, or the like. To implement the rotational connection of the transmission structures, the input signal signal_CH0 must be transmitted upward from the transmission structure T0 of the logic chip to the interconnection structure T0 of the memory chip 0 (instead of accessing the transmission structure T0 of the memory chip 0) and then horizontally transmitted from the interconnection structure T0 below the memory chip 0 to the transmission structure T1 of the memory chip 0. That is, for the structure shown in FIG. 2B, a signal also needs to pass through the interconnection structures in each memory chip during the signal process, and the situation is similar for outputting signals, which inevitably results in increased parasitic resistance and increased process complexity.

In particular, in the chip stack structures of FIG. 2A and FIG. 2B, active surfaces of all chips are upward facing, i.e., different memory chips are stacked in a back-to-face manner. The memory chips and the logic chip are also stacked in a back-to-face manner, i.e., the bottom surface of the upper chip is in contact with the top surface of the lower chip.

In summary, in one aspect, the chip stack structure in FIG. 2A needs to be provided with more transmission structures to transmit corresponding signals, which, together with the corresponding driving circuits and data selectors, cause a large load and large parasitic capacitance, while the chip stack structure in FIG. 2B causes large parasitic resistance due to the rotational configuration; in another aspect, the stack structures in FIG. 2A and FIG. 2B both have some problems and cannot be directly applied to face-to-face stack structures. Specifically, if a face-to-face chip stack structure is desired to be further realized, one method is to use two sets of masks to manufacture two different chips as a chip with active surface facing upward and a chip with active surface facing downward, respectively, and this process is characterized by high process complexity and uncontrollable cost; another method is to form an additional group of transmission structures and connect the two groups of transmission structures to the same driving circuit in the memory chip, but the method may result in complex internal wiring of the memory chip, which may not only increase the process complexity, but also increase the power consumption.

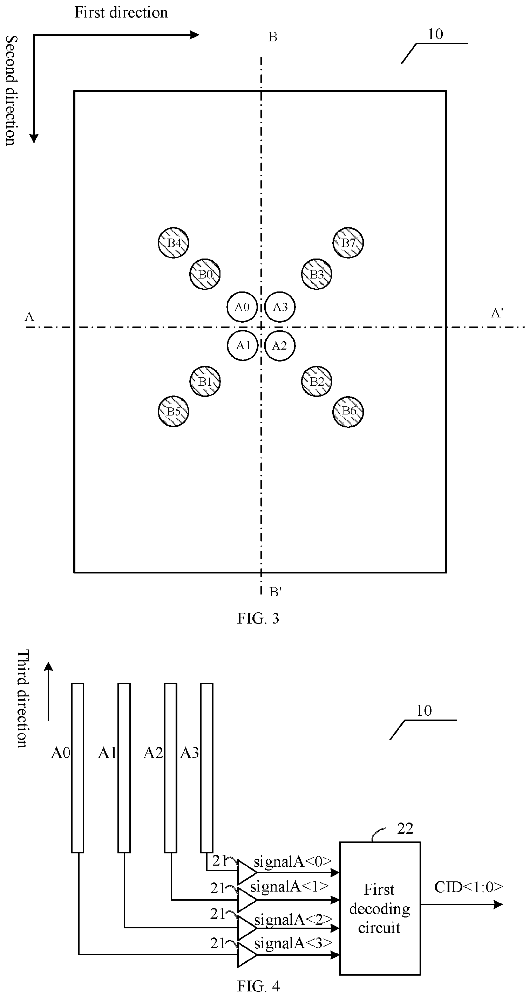

In yet another embodiment of the present disclosure, referring to FIG. 3, a schematic structural diagram of a memory chip 10 provided according to an embodiment of the present disclosure is shown. The top surface of the memory chip 10 has a first axis AA' and a second axis BB' that are perpendicular to each other and intersect at a center of the top surface; the first axis AA' is parallel to one edge of the top surface, and the second axis BB' is parallel to the other edge of the top surface. In FIG. 3, the first axis AA' extends along a first direction and the second axis BB' extends along a second direction, but this does not constitute a relevant limitation.

The memory chip 10 includes four first transmission structures (A0-A3) and B second transmission structure groups, and FIG. 3 is illustrated with B = 2; the first second transmission structure group is represented as B0-B3, and the second second transmission structure group is represented as B4-B7. It should be understood that FIG. 3 is merely an example, and the specific positions of the first transmission structure group and second transmission structure group are not limited to those shown in FIG. 3. In addition, although the following is illustrated with B = 2, B may be another natural number, and other situations should be understood adaptively.

Referring to FIG. 3, four first transmission structures are arranged symmetrically about the first axis AA', and four first transmission structures are arranged symmetrically about the second axis BB'; each second transmission structure group includes four second transmission structures, and the four second transmission structures are arranged symmetrically about the first axis AA and the four second transmission structures are arranged symmetrically about the second axis BB'.

The memory chip 10 receives one first identification signal from each first transmission structure and generates a chip position identification code CID based on four first identification signals. The signal levels transmitted by the four second transmission structures in the same second transmission structure group are the same, and the memory chip 10 receives one second identification signal from each second transmission structure group and generates a stack position identification code SID based on B second identification signals.

Here, the memory chip 10 determines a position number thereof in the chip stack structure to which the memory chip belongs based on the stack position identification code SID and the chip position identification code CID.

In a specific embodiment, four memory chips 10 are stacked to form a stack unit, and the logic chip and a plurality of stack units further form a chip stack structure. The chip position identification code CID indicates a position number of the memory chip 10 in the stack unit to which the memory chip belongs; the stack position identification code SID indicates a position number of a stack unit to which the memory chip 10 belongs in the chip stack structure to which the stack unit belongs. Taking a chip stack unit formed by stacking one logic chip and eight memory chips (every four memory chips are a stack unit, and there are two stack units), the CID has a 2-bit sub-signal CID<1:0> and the SID has a 2-bit sub-signal SID<1:0>. In the normal operation stage of the memory chip 10, numbering is performed by starting from the logic chip (i.e., bottom to top), and the CID<1:0> and SID<1:0> of each chip are as shown in Table 1; in the initialization stage of the memory chip 10, numbering is performed from the side away from the logic chip (i.e., from top to bottom), and the CID<1:0> and SID<1:0> of each chip are as shown in Table 2.

**Table 1**

| | CID<1:0> | SID<1:0> |
|---|---|---|
| Memory chip 7 | 11 | 01 |
| Memory chip 6 | 10 | 01 |
| Memory chip 5 | 01 | 01 |
| Memory chip 4 | 00 | 01 |
| Memory chip 3 | 11 | 00 |
| Memory chip 2 | 10 | 00 |
| Memory chip 1 | 01 | 00 |
| Memory chip 0 | 00 | 00 |
| Logic chip | 00 | 00 |

**Tahle 2**

| | CID<1:0> | SID<1:0> |
|---|---|---|
| Memory chip 7 | 00 | 00 |
| Memory chip 6 | 01 | 00 |
| Memory chip 5 | 10 | 00 |
| Memory chip 4 | 11 | 00 |
| Memory chip 3 | 00 | 01 |
| Memory chip 2 | 01 | 01 |
| Memory chip 1 | 10 | 01 |
| Memory chip 0 | 11 | 01 |
| Logic chip | 11 | 10 |

In some embodiments, referring to FIG. 4, the memory chip 10 further includes four first driving circuits 21 and a first decoding circuits 22, where the four first driving circuits 21 are coupled to four first transmission structures (A0-A3) in a one-to-one correspondence; the first decoding circuit 22 is coupled to the four first driving circuits 21 and is configured to receive four first identification signals signalA<3:0> via the four first driving circuits 21 and decode the four received first identification signals signalA<3:0> to generate the chip position identification code CID<1:0>.

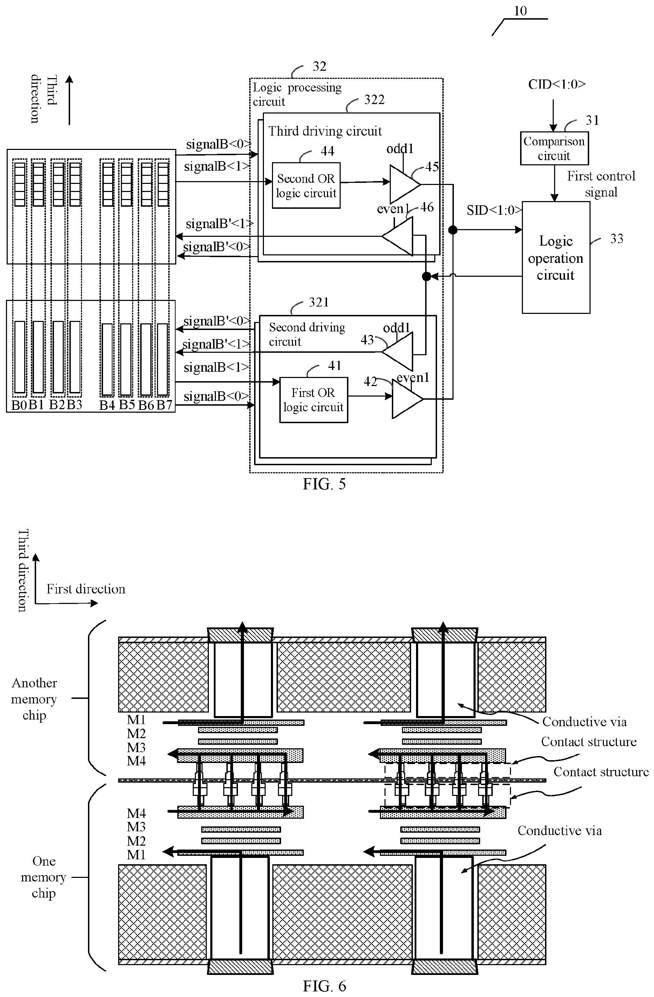

In some embodiments, referring to FIG. 5, the memory chip 10 further includes a comparison circuit 31, a logic processing circuit 32, and a logic operation circuit 33.

First, the comparison circuit 31 is coupled to the first decoding circuit 22 and is configured to generate an effective first control signal when the chip position identification code CID<1:0> is the same as the preset chip position identifier, where the preset chip position identifier indicates that the memory chip 10 is the last chip in the stack unit to which the memory chip belongs. Illustratively, referring to Table 1 or Table 2, the preset chip position identifier = 11; for Table 1, i.e., when the memory chips are numbered from bottom to top, the memory chips 3 and 7 are the last chips in the respective stack units to which the memory chips belong; for Table 2, i.e., when the memory chips are numbered from top to bottom, the memory chip 4 and the memory chip 0 are the last chips in the respective stack unit to which the memory chips belong. Here, being effective may refer to a high-level state, and being ineffective may refer to a low-level state, or vice versa.

Next, the logic processing circuit 32 is coupled to B second transmission structure groups and is configured to receive one second identification signal SignalB from each second transmission structure group and generate the stack position identification code SID<1:0> based on the received B second identification signals SignalB<1:0> (illustrated with B = 2). Here, the signals transmitted by the four second transmission structures in the same second transmission structure group are subjected to an OR logic to form one second identification signal.

Thirdly, the logic operation circuit 33 is coupled to the comparison circuit 31 and the logic processing circuit 32 and is configured to receive the first control signal and the stack position identification code SignalB<1:0>, perform a plus-one operation on the stack position identification code SignalB<1:0> to generate and output a second identification signal SignalB'<1:0> of a next memory chip 10 when the first control signal is effective, and output the stack position identification code SignalB<1:0> of the memory chip 10 as the second identification signal SignalB'<1:0> of the next memory chip 10 when the first control signal is ineffective.

Finally, the logic processing circuit 32 is further configured to receive the second identification signals SignalB'<1:0> of the next memory chip 10 output by the logic operation circuit 33 and transmit them to the next memory chip 10 through B second transmission structure groups, where the i^{th} second identification signal SignalB'<i-1> of the next memory chip 10 is transmitted to the next memory chip 10 via the i^{th} second transmission structure group, and i is a natural number less= than or equal to B.

It should be noted that the signal values of the second identification signals SignalB<1:0> are respectively the same as the signal values of the stack position identification codes SID<1:0>, except that they are located at different circuit positions, and there may be signal transmission and enhancement in the middle.

As such, for the first three memory chips 10 in each stack unit, each memory chip only needs to directly transmit the stack position identification code SID to a next memory chip 10; however, for the last one memory chip 10 in each stack unit, it performs a plus-one operation on the stack position identification code SID and then transmits the stack position identification code SID to a next memory chip 10.

In some embodiments, referring to FIG. 5, each second transmission structure (B0-B7) has a conductive via (a portion filled with no pattern) and a contact structure (a portion filled with transverse lines) spaced apart along a third direction; the conductive via penetrates through a substrate of the memory chip 10 along the third direction and the contact structure penetrates through the top surface, and the conductive via and the contact structure have no direct contact part along the third direction.

Only one example of the conductive via and the contact structure is provided; referring to FIG. 6, a schematic diagram of a second contact structure in two memory chips 10 stacked in a face-to-face manner is shown. As shown in FIG. 6, the conductive via penetrates through the substrate (active surface of the chip) upward from the bottom surface side and is coupled to the internal circuit of the memory chip 10 via the first metal layer M1; the contact structure penetrates through the top surface from the fourth metal layer M4 and is coupled to the internal circuit of the memory chip 10 via the fourth metal layer M4; meanwhile, the contact structure of the memory chip 10 and the contact structure of another memory chip 10 are electrically connected to achieve electrical connection among different memory chips 10. In FIG. 6, each contact structure also includes four sub-contact structures; however, this does not constitute a relevant limitation, and a contact structure may include only one sub-contact structure.

Referring to FIG. 5, the logic processing circuit 32 includes B second driving circuits 321 and B third driving circuits 322; the i^{th} second driving circuit 321 is coupled to the conductive via of each second transmission structure in the i^{th} second transmission structure group. The i^{th} second driving circuit 321 is further coupled to the logic operation circuit 33; i is a natural number and is less than or equal to B; the i^{th} third driving circuit 322 is coupled to the contact structure of each second transmission structure in the i^{th} second transmission structure group; the i^{th} third driving circuit 322 is further coupled to the logic operation circuit 33.

In some embodiments, the logic processing circuit 32 is further coupled to the first decoding circuit 22 (not shown in this figure, but understood in combination with the text) and is configured to: receive a chip position identification code CID<1:0>; in the case that the chip position identification code CID<1:0> indicates that the memory chip 10 is located at an even-numbered position, receive the second identification signal SignalB<1:0> of the memory chip from the conductive via of each second transmission structure in the corresponding second transmission structure group via the second driving circuit 321 and send the generated stack position identification code SID<1:0> to the logic operation circuit 33; and send the second identification signal SignalB'<1:0> of the next memory chip 10 output by the logic operation circuit 33 to the contact structure of each second transmission structure in the corresponding second transmission structure group via the third driving circuit 322.

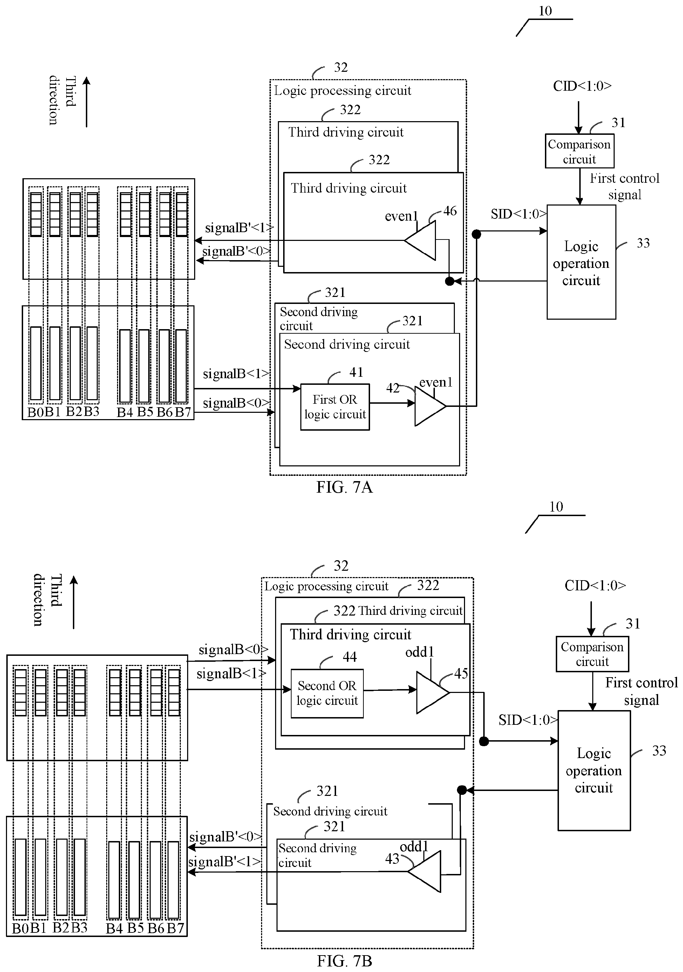

For example, referring to FIG. 7A, the conductive vias of B0-B3 are all used for transmitting the second identification signal SignalB<0>, the conductive vias of B4-B7 are all used for transmitting the second identification signal SignalB<1>, the first second driving circuit 321 receives SignalB<0> from the conductive vias of B0-B3, and the second second driving circuit 321 receives SignalB<1> from the conductive vias of B4-B7; the logic operation circuit 33 generates a second identification signal SignalB'<1:0> of the next memory chip 10 based on SignalB<1:0> (SID<1:0> in FIG. 7A), the first third driving circuit 322 sends SignalB'0 to the contact structures of B0-B3, and the second third driving circuit 322 sends SignalB'1 to the contact structures of B4-B7.

Meanwhile, the logic processing circuit 32 is further configured to, in the case that the chip position identification code CID<1:0> indicates that the memory chip 10 is in an odd-numbered position, receive a second identification signal SignalB<1:0> of the memory chip from the contact structure of each second transmission structure in the corresponding second transmission structure group via the third driving circuits 322, send the generated stack position identification code SID<1:0> to the logic operation circuit 33, and send the second identification signal SignalB'<1:0> of the next memory chip 10 output by the logic operation circuit 33 via the second driving circuits 321 to the conductive via of each second transmission structure in the corresponding second transmission structure group.

For example, referring to FIG. 7B, the contact structures of B0-B3 are all used for transmitting the second identification signal SignalB<0>, the contact structures of B4-B7 are all used for transmitting the second identification signal SignalB<1>, the first third driving circuit 322 receives SignalB<0> from the contact structures of B0-B3, and the second third driving circuit 322 receives SignalB<1> from the contact structures of B4-B7; the logic operation circuit 33 generates a second identification signal SignalB'<1:0> of the next memory chip 10 based on SignalB<1:0> (SID<1:0> in FIG. 7B), the first second driving circuit 321 sends SignalB'<0> to the conductive vias of B0-B3, and the second second driving circuit 321 sends SignalB'<1> to the conductive vias of B4-B7.

That is, the second transmission structure supports both top-to-bottom transmission and bottom-to-top transmission, thereby implementing the two numbering mechanisms of the initialization process and the normal operation process. Specifically, the memory chip 10 provided by the embodiment of the present disclosure supports face-to-face stacking; referring to the foregoing Table 1 and Table 2, the memory chip 0 and the memory chip 1 are stacked in a face-to-face manner, the memory chip 1 and the memory chip 2 are stacked in a back-to-back manner, the memory chip 2 and the memory chip 3 are stacked in a face-to-face manner,..., and so on. As such, when signals are transmitted upward from the logic chip, the memory chip 0, the memory chip 2, the memory chip 4, and the memory chip 6 are facing upward, and the second identification signal SignalB<1:0> needs to be acquired from the conductive vias (of the second transmission structures) penetrating through the substrate, and the newly generated second identification signal SignalB'<1:0> is sent to the contact structures (of the second transmission structures) penetrating through the top surface; the memory chip 1, the memory chip 3, the memory chip 5, and the memory chip 7 are facing downward, and the second identification signal SignalB<1:0> needs to be acquired from the contact structures (of the second transmission structures) penetrating through the top surface, and the newly generated second identification signal SignalB'<1:0> is sent to the conductive vias. When transmitting from the uppermost memory chip down to the logic chip, the transmission direction of each memory chip is exactly opposite to what is described above. Specifically, the memory chip 0, the memory chip 2, the memory chip 4, and the memory chip 6 are facing upward, and the second identification signal SignalB<1:0> needs to be acquired from the contact structures (of the second transmission structures) penetrating through the top surface, and the newly generated second identification signal SignalB'<1:0> is sent to the conductive vias (of the second transmission structures) penetrating through the substrate; the memory chip 1, the memory chip 3, the memory chip 5, and the memory chip 7 are facing downward, and the second identification signal SignalB<1:0> needs to be acquired from the conductive vias (of the second transmission structures) penetrating through the substrate, and the newly generated second identification signal SignalB'<1:0> is sent to the contact structures (of the second transmission structures) penetrating through the top surface.

Therefore, in some embodiments, referring to FIG. 5, the second driving circuit 321 includes a first OR logic circuit 41, an even driving input circuit 42, and an odd driving output circuit 43; the input end of the first OR logic circuit 41 is coupled to the conductive via of each second transmission structure in the corresponding second transmission structure group, the even driving input circuit 42 is coupled between the output end of the first OR logic circuit 41 and the input end of the logic operation circuit 33, and the odd driving output circuit 43 is coupled between the output end of the logic operation circuit 33 and the conductive via of each second transmission structure in the corresponding second transmission structure group;
the third driving circuit 322 includes a second OR logic circuit 44, an even driving output circuit 46, and an odd driving input circuit 45; the input end of the second OR logic circuit 44 is coupled to the contact structure of each second transmission structure of the corresponding second transmission structure group, the odd driving input circuit 45 is coupled between the output end of the second OR logic circuit 44 and the input end of the logic operation circuit 33, and the even driving output circuit 46 is coupled between the output end of the logic operation circuit 33 and the contact structure of each second transmission structure of the corresponding second transmission structure group;
the control end of the odd driving input circuit 45 and the control end of the odd driving output circuit 43 both receive a first odd switching signal odd1; the control end of the even driving input circuit 42 and the control end of the even driving output circuit 46 both receive a first even switching signal even1; if the chip position identification code CID<1:0> indicates that the memory chip is in an odd-numbered position, the first odd switching signal odd1 is in an enabled state, and the first even switching signal even1 is in a disabled state; if the chip position identification code CID<1:0> indicates that the memory chip is in an even-numbered position, the first odd switching signal odd1 is in a disabled state, and the first even switching signal even1 is in an enabled state.

Here, the specific code value of the odd-numbered position is determined according to an actual application scenario, and the specific code value of the even-numbered position is determined according to the actual application scenario. In particular, the odd-numbered positions and even-numbered positions are not only parity of the actual positions of the chips; even-numbered positions refer to the positions of the memory chips requiring transmission of the second identification signal from the bottom surface to the top surface, and odd-numbered positions refer to the positions of the memory chips requiring transmission of the second identification signal from the top surface to the bottom surface. Referring to the foregoing Table 1 and Table 2, when CID<1:0> = 00/10, it can be considered to be in an odd-numbered position; when CID<1:0>=01/11, it can be considered to be in an even-numbered position.

As such, referring to FIG. 7A, if the memory chip 10 is located at an even-numbered position, the even driving input circuit 42 and the even driving output circuit 46 are in conductive connection, the memory chip 10 receives the second identification signal signalB<1:0> from the conductive vias of the second transmission structures to generate its stack position identification code SID<1:0>, and sends out the newly generated second identification signal signalB'<1:0> through the contact structures of the second transmission structures, i.e., the second identification signal is transmitted from the bottom surface to the top surface. Referring to FIG. 7B, if the memory chip 10 is located at an odd-numbered position, the odd driving input circuit 45 and the odd driving output circuit 43 are in conductive connection, the memory chip 10 receives the second identification signal signalB<1:0> from the contact structures of the second transmission structures to generate its stack position identification code SID<1:0>, and sends out the newly generated second identification signal signalB'<1:0> through the conductive vias of the second transmission structures, i.e., the second identification signal is transmitted from the top surface to the bottom surface.

It should be further noted that, the signals transmitted by the four second transmission structures are subjected to an OR logic to generate a corresponding second identification signal, which has the following advantages: the signals transmitted by the four second transmission structures are subjected to an OR logic to generate one second identification signal, and if a path corresponding to one of the second transmission structures is damaged, the overall transmitted second identification signal is not affected, and on the contrary, the other second transmission structures in the same group can still ensure the normal transmission of the second identification signal, so that the anti-damage capability of the memory chip is improved.

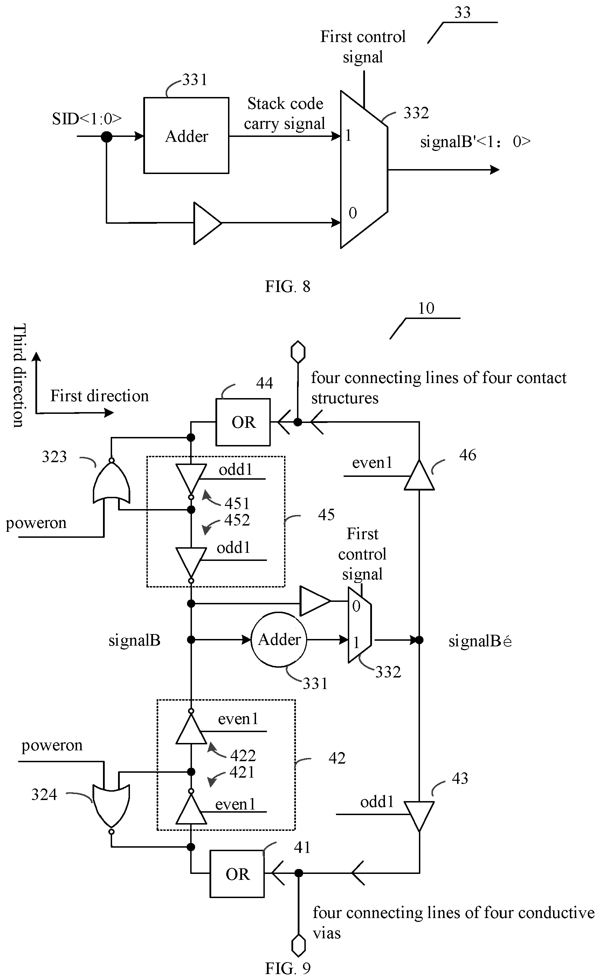

In some embodiments, as shown in FIG. 8, the logic operation circuit 33 includes: an adder 331 and a select circuit 332. The adder 331 is configured to perform a plus-one operation to the stack position identification code SID<1:0> and output a stack code carry signal; the select circuit 332 is configured to output the stack code carry signal as a second identification signal signalB'<1:0> of the next memory chip 10 if the first control signal is effective and directly output the stack position identification code SID as the second identification signal signalB'<1:0> of the next memory chip 10 if the first control signal is ineffective.

Referring to FIG. 8, to ensure consistent delay while ensuring signal strength and signal transmission delay, the stack position identification code SID<1:0> may be transmitted to the select circuit 332 through a buffer (or also known as a driver).

As such, for the last memory chip of each stack unit, the result obtained from performing a plus-one operation on the stack position identification code SID<1:0> is output to the next memory chip; for the other memory chips of each stack unit, the stack position identification code SID<1:0> is directly transmitted to the next memory chip.

In some embodiments, referring to FIG. 9, a schematic diagram of signal transmission of the memory chip 10 is shown. As shown in FIG. 9, the logic processing circuit 32 further includes a weak driving circuit (referring to 323 and 324 in FIG. 9).

The logic processing circuit 32 is further configured to generate a second identification signal signalB<1 :0> of a default state based on the weak driving circuit if the second transmission structure does not transmit an effective signal, and generate a second identification signal signalB<1:0> based on the effective signal transmitted by the second transmission structure if the second transmission structure transmits the effective signal.

Illustratively, the default state is low level. In short, if there is no signal transmission in the second transmission structure (specifically, there is no external strong driving signal transmission in the second transmission structure), the second transmission structure is in a low-level state. As such, the weak driving circuit can enable the lowest or the uppermost chip to generate the second identification signal signalB<1:0> of a default state, and the transmission from bottom to top in the initialization process or the transmission from top to bottom in the normal operation process can be met only by changing the transmission direction of the second identification signal; in addition, as mentioned above, the signals transmitted by the four second transmission structures are subjected to an OR logic to generate one second identification signal, and if the path corresponding to one of the second transmission structures is damaged, the second transmission structure is in the low-level state, and the overall transmitted second identification signal is not affected.

In some embodiments, as shown in FIG. 9, the weak driving circuit includes B first logic devices 323 (only one is shown in FIG. 9) and B second logic devices 324 (only one is shown in FIG. 9).

Each odd driving input circuit 45 is coupled to one first logic device 323; the odd driving input circuit 45 includes a first inverting driving unit 451 and a second inverting driving unit 452; the output end of the second OR logic circuit 44 is connected to the input end of the first inverting driving unit 451, the output end of the first inverting driving unit 451 is connected to the input end of the second inverting driving unit 452, the output end of the second inverting driving unit 452 is connected to the input end of the logic operation circuit 33, and the control end of the first inverting driving unit 451 and the control end of the second inverting driving unit 452 both receive the first odd switching signal odd1; the output end of the first logic device 323 is connected to the input end of the first inverting driving unit 451, the first input end of the first logic device 323 receives a power-on indication signal poweron, and the second input end of the first logic device 323 is connected to the output end of the first inverting driving unit 451.

Each even driving input circuit 42 is coupled to one second logic device 324; the even driving input circuit 42 includes a third inverting driving unit 421 and a fourth inverting driving unit 422; the output end of the first OR logic circuit 41 is connected to the input end of the third inverting driving unit 421, the output end of the third inverting driving unit 421 is connected to the input end of the fourth inverting driving unit 422, the output end of the fourth inverting driving unit 422 is connected to the input end of the logic operation circuit 33, and the control end of the third inverting driving unit 421 and the control end of the fourth inverting driving unit 422 both receive the first even switching signal even1; the output end of the second logic device 324 is connected to the input end of the third inverting driving unit 421, the first input end of the second logic device 324 receives a power-on indication signal poweron, and the second input end of the second logic device 324 is connected to the output end of the third inverting driving unit 421.

In a specific embodiment, the first logic device 323 and the second logic device 324 are both two-input NOR gates; after the memory chip 10 is powered on, the power-on indication signal poweron is a high level; the second identification signal of a default state is a low level. However, this does not constitute a relevant limitation.

As such, after the weak driving circuit with the above structure is powered on, in the case that the second identification signal is determined, the input level state and output level state of the weak driving circuit are kept locked, and a static current path does not exist, such that the power consumption of the circuit is effectively reduced, and meanwhile the influence on other structures is avoided.

In another embodiment, the weak driving circuit may be implemented by a fixed resistance (relatively large value) grounded or in other ways not mentioned.

Illustratively, the first transmission structure may penetrate through the conductive via of the entire chip along a third direction, and the first transmission structure may also be of a type similar to the second transmission structure, i.e., consisting of a conductive via and a contact structure that do not penetrate through the entire memory chip. Here, the conductive via at least includes a through-silicon-via (TSV), specifically a vertical interconnection structure, or in other embodiments, the conductive via may be another via with a conductive function, which is not specifically limited.

Specifically, the first transmission structure is manufactured by any one or more of a via-first process, a via-middle process, a via-last process, and a back side via-last process; the conductive via in the second transmission structure is manufactured by any one or more of a via-first process and a via-middle process; different first transmission structures are electrically isolated from each other and different second transmission structures are also electrically isolated from each other.

It should be noted that the via-first process refers to a via process method in which a via structure is manufactured before a device structure, such as a metal oxide semiconductor field effect transistor (MOSFET, or MOS transistor), is manufactured. The via-middle process refers to a via process in which a via structure is formed during the manufacturing process in the process flow, often after a device is formed and before a stack is manufactured. The via-last process refers to a manufacturing process in which vias are formed at the front side of a wafer after a back end of line (BEOL) process is completed. The back side via-last process refers to a manufacturing process in which a via structure is formed at the back side of a wafer after a BEOL process is completed. That is, the via-first process may refer to first manufacturing vias and then manufacturing a circuit; the via-middle process may refer to first manufacturing a circuit and a portion of metal layers, then manufacturing vias, and finally manufacturing the remaining vias; the via-last process and the back side via-last process may refer to first manufacturing a circuit and metal layers and then manufacturing vias.

Additionally, the contact structure may include at least one or more of the following structures: a copper pillar, a metal interconnection line, and a bump.

As such, the embodiment of the present disclosure provides a memory chip 10, in which the transmission structure has 4-quadrant symmetry (arranged symmetrically about the first axis and about the second axis) and can be directly applied to face-to-face, back-to-back, and back-to-face stack structures; a rotation connection structure as shown in FIG. 2B (see the following description) can be implemented by a physical direct connection configuration, and both parasitic capacitance and parasitic resistance are relatively low. Meanwhile, the transmission principle of the chip position identification code and the stack position identification code is provided, which has the following advantages: (1) the transmission of the chip position identification code CID can be achieved by only using four first transmission structures without respectively arranging independent transmission structures for the chip position identification code CID of each memory chip, so that the number of the first transmission structures can be reduced, and the chip area and the cost can be saved; (2) the transmission of the stack position identification code SID is performed through a second transmission structure formed by the conductive via and the contact structure together, and the last one memory chip of each stack unit is subjected to a plus-one operation, so that the transmission can be achieved only by two second transmission structure groups (i.e., eight second transmission structures) without respectively arranging independent transmission structures for the chip position identification code SID of each memory chip, and thereby the number of the second transmission structures can be reduced, and the chip area and the cost are saved; (3) the second transmission structure can enable transmission from top to bottom or from bottom to top, so that transmission logic can be well achieved in the case of face-to-face stacking, and two numbering mechanisms in an initialization process and a normal operation process are supported; (4) the second transmission structure group transmits one bit of the stack position identification code SID together, so that correct transmission can still be ensured when part of the second transmission structures fail, and the failure handling performance is improved.

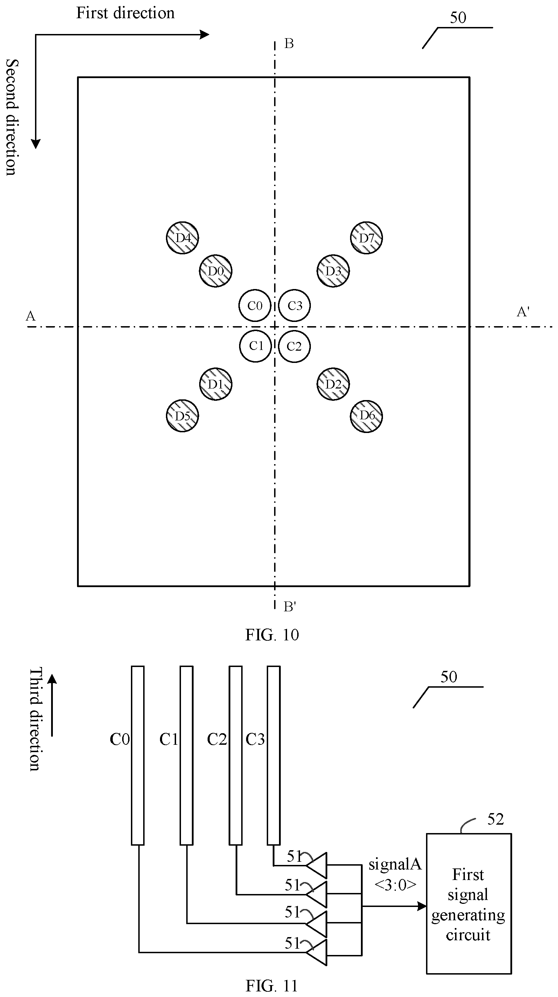

In still another embodiment of the present disclosure, referring to FIG. 10, a logic chip 50 provided according to an embodiment of the present disclosure is shown. A top surface of the logic chip 50 has a first axis AA' and a second axis BB' that are perpendicular to each other and intersect at a center of the top surface, the first axis AA' is parallel to one edge of the top surface, and the second axis BB' is parallel to the other edge of the top surface.

The logic chip 50 includes four third transmission structures (C0-C3) and B fourth transmission structure groups, where B is a natural number. FIG. 10 is illustrated with B = 2. The first fourth transmission structure group is represented as D0-D3, and the second fourth transmission structure group is represented as D4-D7. The four third transmission structures are arranged symmetrically about the first axis AA', and the four third transmission structures are arranged symmetrically about the second axis BB'; each fourth transmission structure group includes four fourth transmission structures, and the four fourth transmission structures are arranged symmetrically about the first axis AA' and the four fourth transmission structures are arranged symmetrically about the second axis BB'.

The logic chip 50 is configured to generate four first identification signals and transmit the four first identification signals to four third transmission structures in a one-to-one correspondence, where the four first identification signals indicate the chip position identification code of the memory chip (i.e., a memory chip 0) adjacent to the logic chip 50; the logic chip 50 is further configured to receive one second identification signal from each fourth transmission structure group and generate a stack position identification code based on B second identification signals in an initialization process, or generate B second identification signals of a default state and transmit one second identification signal to one fourth transmission structure group in a normal operation stage, so that other memory chips receive corresponding second identification signals from respective fourth transmission structure groups to generate their stack position identification codes.

In some embodiments, referring to FIG. 11, the logic chip 50 further includes a first signal generating circuit 52 and four fourth driving circuits 51, where the four fourth driving circuits 51 are coupled to the four third transmission structures C0-C3 in a one-to-one correspondence; the first signal generating circuit 52 is coupled to the four fourth driving circuits 51; the first signal generating circuit is configured to generate four first identification signals signalA<3:0> in an initialization process, where the level states of the four first identification signals signalA<3:0> are a first combination value, and the first signal generating circuit is configured to generate four first identification signals signalA<3:0> in the normal operation process, where the level states of the four first identification signals are a second combination value; the first combination value and the second combination value are not completely identical.

In particular, for the logic chip 50, the first identification signal signalA<0> is not necessarily transmitted by the first transmission structure C0, and may be transmitted by the first transmission structure C3 or the first transmission structure C2; the remaining first identification signals signalA also have similar problems, and it is necessary to consider the stacking form of the logic chip 50 and the memory chip 10, which can be understood with further reference to the following illustration of the chip stack structure.

Illustratively, in a normal operation process, four first identification signals signalA<3:0> = 0001, so that CIDs<1:0> of the logic chip and the memory chip 0 are 00, referring to Table 1 above; in an initialization process, four first identification signals signalA<3:0> = 1000, so that CIDs of the logic chip and the memory chip 0<1:0> are 11, referring to Table 2 above. As such, for the chip stack structure 50, the serial number of each memory chip during the normal operation is counted by starting from the logic chip 50 (for example, Table 1), and the serial number of each memory chip in an initialization process is counted by starting from the side far away from the logic chip 50 (for example, Table 2).

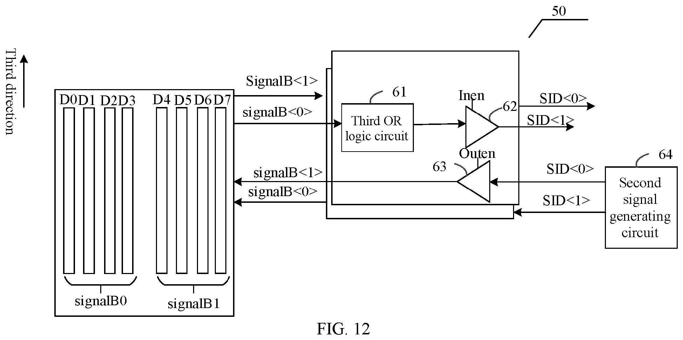

In some embodiments, referring to FIG. 12, FIG. 12 is illustrated with B = 2. The logic chip 50 further includes a second signal generating circuit 64, B third OR logic circuits 61, B control input circuits 62, and B control output circuits 63.

The second signal generating circuit 64 is coupled to the B control output circuits 63 and is configured to generate B second identification signals of a default state in a normal operation stage and transmit the i^{th} second identification signal signalB<i-1> to the input end of the i^{th} control output circuit 63 in a one-to-one correspondence, where the output end of the i^{th} control output circuit 63 is coupled to each fourth transmission structure in the i^{th} fourth transmission structure group; i is a natural number less than or equal to B; each fourth transmission structure in the i^{th} fourth transmission structure group is coupled to the input end of the i^{th} third OR logic circuit 61, the output end of the third OR logic circuit 61 is coupled to the input end of the i^{th} control output circuit 63, and the output end of the i^{th} control input circuit 62 is coupled to the internal circuit of the logic chip 50;

in an initialization process, the output end of the i^{th} control input circuit 62 outputs the i^{th} second identification signal signalB<i-1> (also equivalent to SID<i-1> in FIG. 12) to the internal circuit of the logic chip 50;
where the control end of the control output circuit 63 receives the output enabled signal Outen, and the control end of the control input circuit 62 receives the input enabled signals Inen; if the logic chip 50 is in a normal operation stage, the input enabled signal Inen is in a disabled state, and the output enabled signal Outen is in an enabled state; if the logic chip 50 is in an initialization process, the input enabled signal Inen is in an enabled state, and the output enabled signal Outen is in a disabled state.

In other embodiments, the second signal generating circuit 64 and the control output circuit 63 may not be provided, but a weak driving circuit similar to that in the foregoing description is provided to generate the second identification signal of the default state.

As such, in a normal operation stage, four first identification signals signalA<3:0> = 0001, and the chip position identification code CID<1:0> = 00 (even-numbered position), and thereby the control output circuit 63 is in an enabled state (on), the control input circuit 62 is in a disabled state (off), and the SID<1:0> generated by the second signal generating circuit 64 at this time is 00, which is transmitted upwards as signalB<1:0> along the fourth transmission structure group; taking a chip stack structure formed by the logic chip 50 and eight memory chips as an example, in the initialization process, the four first identification signals signalA<3:0> in the logic chip is 1000, and the chip position identification code CID<1:0> = 11 (odd-numbered position), and thereby the control output circuit 63 is in the disabled state, the control input circuit 62 is in the enabled state, and at this time, the logic chip 50 receives signalB<1:0>=10 from the fourth transmission structure group, i.e., SID<1:0> = 10.

In some embodiments, the third transmission structure or the fourth transmission structure is manufactured by any one or more of a via-first process, a via-middle process, a via-last process, and a back side via-last process; different third transmission structures are electrically isolated from each other and different fourth transmission structures are also electrically isolated from each other. That is, each of the third and fourth transmission structures may be a conductive via penetrating through the entire chip, or may take the form of a conductive via + contact structure that does not penetrate through the entire chip, or may take other forms not mentioned.

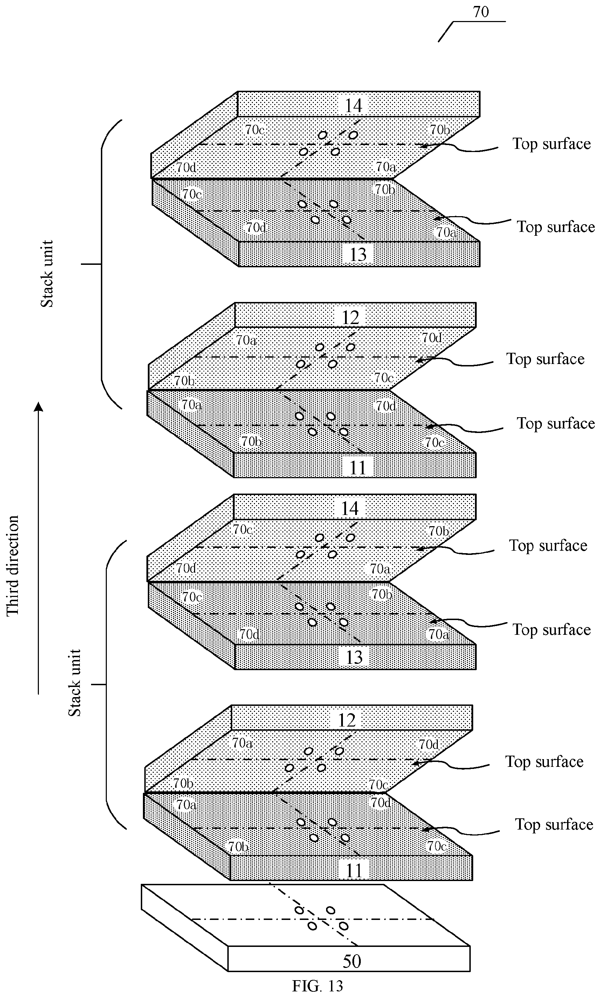

In still another embodiment of the present disclosure, referring to FIG. 13, a chip stack structure 70 provided according to an embodiment of the present disclosure is shown. The chip stack structure 70 includes the aforementioned logic chip 50 and at least one stack unit, and the logic chip 50 and the at least one stack unit are sequentially stacked along a third direction; each stack unit includes a first memory chip 11, a second memory chip 12, a third memory chip 13, and a fourth memory chip 14 sequentially stacked along the third direction, and the third direction is perpendicular to a top surface of each memory chip; the structure of each of the first memory chip 11, the second memory chip 12, the third memory chip 13, and the fourth memory chip 14 is that of the aforementioned memory chip 10.

The first memory chip 11 and the second memory chip 12 are stacked in a face-to-face manner, the second memory chip 12 and the third memory chip 13 are stacked in a back-to-back manner, and the third memory chip 13 and the fourth memory chip 14 are stacked in a face-to-face manner; the logic chip 50 and the first memory chip 11 (in the first stack unit) are stacked in a back-to-back manner; or the logic chip 50 and the first memory chip 11 are stacked in a face-to-back manner.

It should be understood that in FIG. 13, only four (not all) transmission structures are shown, and that these four transmission structures can be understood as four first transmission structures and also as one second transmission structure group.

In the embodiment of the present disclosure, face-to-face stacking means that the top surfaces of two chips are approximately aligned with each other along the third direction and the center points and the first axes and the second axes of the top surfaces of the two chips are all aligned along the third direction; back-to-back stacking means that the top surfaces of two chips are approximately aligned with each other along the third direction; face-to-back stacking means that the top surface of one chip is approximately aligned with the bottom surface of another chip along the third direction. The "chip" may refer to a logic chip or a memory chip in the case that whether it is a logic chip or a memory chip is not specified.

**In** some embodiments, it should be noted that in one possibility, for two chips connected in a face-to-face manner, (positions where the conductive vias are aligned along the third direction in) bonding surfaces of the two chips are electrically connected through a hybrid bonding structure (also referred to as a bonding post); for two chips connected in a back-to-back manner or in a face-to-back manner, (positions where the conductive vias are aligned along the third direction in) bonding surfaces of the two chips are electrically connected through conductive bumps (UBumps, also referred to as microbumps).

**In** another possibility, for two chips connected in a face-to-face manner or for two chips connected in a back-to-back manner or for two chips connected in a face-to-back manner, (positions where the conductive vias are aligned along the third direction in) bonding surfaces of the two chips are connected through a hybrid bonding structure. That is, (positions where the conductive vias are aligned along the third direction in) bonding surfaces of two chips connected in a face-to-face manner are electrically connected through a hybrid bonding structure, and (positions where the conductive vias are aligned along the third direction in) bonding surfaces of two chips connected in a back-to-back manner and (positions where the conductive vias are aligned along the third direction in) bonding surfaces of two chips connected in a face-to-back manner are also electrically connected through a hybrid bonding structure.

**In** yet another possibility, for two chips connected in a face-to-face manner or for two chips connected in a back-to-back manner, (positions where the conductive vias/contact structures are aligned along the third direction in) bonding surfaces of the two chips are connected through conductive bumps. That is, (positions where the conductive vias/contact structures are aligned along the third direction in) bonding surfaces of two chips connected in a face-to-face manner are connected through conductive bumps, and (positions where the conductive vias/contact structures are aligned along the third direction in) bonding surfaces of two chips connected in a back-to-back manner and (positions where the conductive vias/contact structures are aligned along the third direction in) bonding surfaces of two chips connected in a face-to-back manner are also connected through conductive bumps.

Here, the above chip may refer to the logic chip 50 or the memory chip 10.

It should be noted that compared to the conductive bumping process, the face-to-face connection using the hybrid bonding process enables adjacent chips to fit more closely with almost no gaps, thereby greatly reducing the height of the chip stack structure, which is one of the advantages of the face-to-face stacking. Of course, two chips connected in a back-to-back manner may also be connected through a hybrid bonding structure, but the connection performance is not as good as that of face-to-face stacking. It should be further noted that, when the transmission structure in the memory chip is a via of the via-last type or the back side via-last type from the back of the wafer, the bonding between the memory chips is the bonding of the vias; when the transmission structure in the memory chip is a via of the via-first type or the via-middle type, for two memory chips connected in a face-to-face manner, positions where the conductive vias are aligned along the third direction in the bonding surfaces of the two chips may be electrically connected through a hybrid bonding process or a conductive bumping process.

It should be noted that each chip includes a high-bit transmission region and a low-bit transmission region, and an arrow of each chip in FIG. 13 indicates the high-bit transmission region. **In** particular, the high-bit transmission region and the low-bit transmission region in the embodiment of the present disclosure only distinguish two regions of the memory chip, but do not impose any additional limitation and do not have any relationship with high-bit data and low-bit data that are often mentioned in data transmission.

Meanwhile, FIG. 13 is a schematic diagram illustrated with the first axis AA' as a boundary between the high-bit transmission region and the low-bit transmission region. In other embodiments, the second axis BB' may be used as a boundary between the high-bit transmission region and the low-bit transmission region.

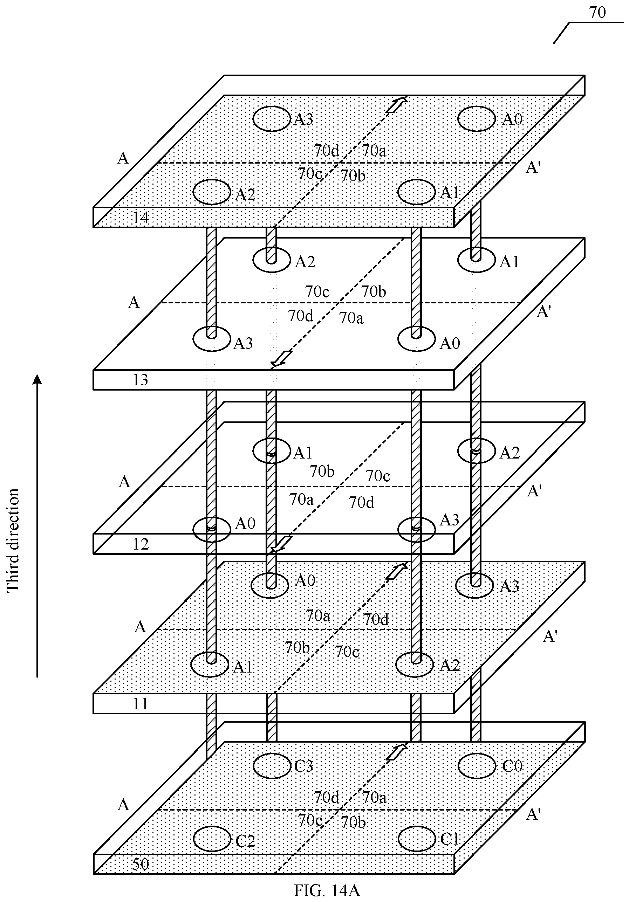

In some embodiments, referring to FIG. 14A, the top surface of the logic chip 50 or each memory chip is divided into 2×2 signal zones; the first signal zone 70a and the second signal zone 70b are arranged symmetrically along the first axis AA', the first signal zone 70a and the fourth signal zone 70d are arranged symmetrically along the second axis BB', and the third signal zone 70c and the fourth signal zone 70d are arranged symmetrically along the first axis AA'; the first axis AA' of the logic chip 50 and the first axis AA' of each 'memory chip are aligned along a third direction, and the second axis BB' of the logic chip 50 and the second axis BB' of each 'memory chip are aligned along the third direction.

Referring to FIG. 14A, in the case that the logic chip 50 and the first memory chip 11 are stacked in a back-to-back manner,
(1) the fourth signal zone 70d of the logic chip 50, the first signal zone 70a of the first memory chip 11, the second signal zone 70b of the second memory chip 12, the third signal zone 70c of the third memory chip 13, and the fourth signal zone 70d of the fourth memory chip 14 are aligned along the third direction;
(2) the third signal zone 70c of the logic chip 50, the second signal zone 70b of the first memory chip 11, the first signal zone 70a of the second memory chip 12, the fourth signal zone 70d of the third memory chip 13, and the third signal zone 70c of the fourth memory chip 14 are aligned along the third direction;
(3) the second signal zone 70b of the logic chip 50, the third signal zone 70c of the first memory chip 11, the fourth signal zone 70d of the second memory chip 12, the first signal zone 70a of the third memory chip 13, and the second signal zone 70b of the fourth memory chip 14 are aligned along the third direction;
(4) the first signal zone 70a of the logic chip 50, the fourth signal zone 70d of the first memory chip 11, the third signal zone 70c of the second memory chip 12, the second signal zone 70b of the third memory chip 13, and the first signal zone 70a of the fourth memory chip 14 are aligned along the third direction.

In short, the way in which the logic chip 50 is arranged at this time is the same as that of the fourth memory chip 14.

It should be noted that, due to process errors, the "alignment" in this embodiment is not an absolute alignment, and the deviation within a reasonable range can be regarded as alignment.

It should be noted that the entire area of the top surface of the logic chip 50 and the area of the top surface of the memory chip 10 may or may not be completely uniform. In the case that the area of the top surface of the logic chip 50 and that of the memory chip 10 are different, the alignment of the above signal zones is adaptively understood as "alignment of orientation".

It should be noted that, referring to FIG. 14A, the transmission structures in the logic chip 50 or each memory chip are arranged symmetrically as four signal zones. Thus, in some embodiments, for each memory chip, the four first transmission structures include a first transmission structure_0 (A0), a first transmission structure_1 (A1), a first transmission structure_2 (A2), and a first transmission structure_3 (A3); the first transmission structure_0 (A0) is located in the first signal zone 70a, the first transmission structure_1 (A1) is located in the second signal zone 70b, the first transmission structure_2 (A2) is located in the third signal zone 70c, and the first transmission structure_3 (A3) is located in the fourth signal zone 70d; for the logic chip 50, the four third transmission structures include a third transmission structure_0 (C0), a third transmission structure_1 (C1), a third transmission structure_2 (C2), and a third transmission structure_3 (C3); the third transmission structure _0 (C0) is located in the first signal zone 70a, the third transmission structure_1 (C1) is located in the second signal zone 70b, the third transmission structure_2 (C2) is located in the third signal zone 70c, and the third transmission structure_3 (C3) is located in the fourth signal zone 70d.

As shown in FIG. 14A, the alignment relationship of the third transmission structures and the first transmission structures is as follows:
(1) the third transmission structure _3 (C3) of the logic chip 50, the first transmission structure_0 (A0) of the first memory chip 11, the first transmission structure_1 (A1) of the second memory chip 12, the first transmission structure_2 (A2) of the third memory chip 13, and the first transmission structure_3 (A3) of the fourth memory chip 14 are aligned along the third direction and connected to form a signal transmission channel;
(2) the third transmission structure_2 (C2) of the logic chip 50, the first transmission structure_1 (A1) of the first memory chip 11, the first transmission structure_0 (A0) of the second memory chip 12, the first transmission structure _3 (A3) of the third memory chip 13, and the first transmission structure_2 (A2) of the fourth memory chip 14 are aligned along the third direction and connected to form a signal transmission channel;
(3) the third transmission structure_1 (C1) of the logic chip 50, the first transmission structure_2 (A2) of the first memory chip 11, the first transmission structure_3 (A3) of the second memory chip 12, the first transmission structure _0 (A0) of the third memory chip 13, and the first transmission structure _1 (A1) of the fourth memory chip 14 are aligned along the third direction and connected to form a signal transmission channel;
(4) the third transmission structure_0 (C0) of the logic chip 50, the first transmission structure_3 (A3) of the first memory chip 11, the first transmission structure_2 (A2) of the second memory chip 12, the first transmission structure_1 (A1) of the third memory chip 13, and the first transmission structure_0 (A0) of the fourth memory chip 14 are aligned along the third direction and connected to form a signal transmission channel.

Each memory chip obtains a 0^{th}-bit first identification signal signalA<0> from the first transmission structure_0 (A0), each memory chip obtains a first-bit first identification signal signalA<1> from the first transmission structure_1 (A1), each memory chip obtains a second-bit first identification signal signalA<2> from the first transmission structure_2 (A2), and each memory chip obtains a third-bit first identification signal signalA<3> from the first transmission structure_3 (A3).

As such, when the logic chip 50 transmits the first identification signals signalA<3:0> of the same combination value, the code values of the first identification signals signalA<3:0> received by the memory chips at different positions in the same stack unit are different, and the first identification signals of different memory chips are not required to be each transmitted by using an independent transmission structure, so that the occupied area of the chip and the cost are reduced.

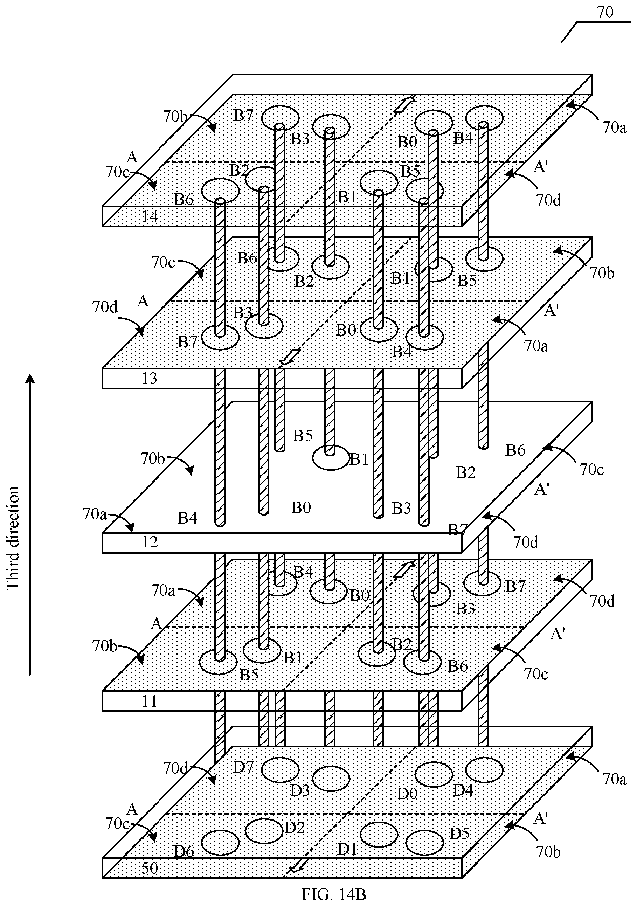

In some embodiments, referring to FIG. 14B, in the case that B = 2, for each memory chip, the first second transmission structure group includes a second transmission structure_0 (B0) to a second transmission structure_3 (B3), and the second second transmission structure group includes a second transmission structure_4 (B4) to a second transmission structure_7 (B7); the second transmission structure_0 (B0) and the second transmission structure_4 (B4) are located in the first signal zone 70a, the second transmission structure_1 (B1) and the second transmission structure_5 (B5) are located in the second signal zone 70b, the second transmission structure_2 (B2) and the second transmission structure_6 (B6) are located in the third signal zone 70c, and the second transmission structure_3 (B3) and the second transmission structure_7 (B7) are located in the fourth signal zone 70d; for the logic chip 50, the first fourth transmission structure group includes a fourth transmission structure_0 (D0) to a fourth transmission structure_3 (D3), and the second fourth transmission structure group includes a fourth transmission structure_4 (D4) to a fourth transmission structure_7 (D7); the fourth transmission structure_0 (D0) and the fourth transmission structure_4 (D4) are located in the first signal zone 70a, the fourth transmission structure_1 (D1) and the fourth transmission structure_5 (D5) are located in the second signal zone 70b, the fourth transmission structure_2 (D2) and the fourth transmission structure_6 (D6) are located in the third signal zone 70c, and the fourth transmission structure_3 (D3) and the fourth transmission structure_7 (D7) are located in the fourth signal zone 70d.

As shown in FIG. 14B, the alignment relationship of the fourth transmission structures and the second transmission structures is as follows:
(1) the fourth transmission structure_3 (D3) of the logic chip 50, the second transmission structure _0 (B0) of the first memory chip 11, the second transmission structure_1 (B1) of the second memory chip 12, the second transmission structure_2 (B2) of the third memory chip 13, and the second transmission structure_3 (B3) of the fourth memory chip 14 are aligned along the third direction and connected to form a signal transmission channel;
(2) the fourth transmission structure_2 (D2) of the logic chip 50, the second transmission structure _1 (B1) of the first memory chip 11, the second transmission structure_0 (B0) of the second memory chip 12, the second transmission structure_3 (B3) of the third memory chip 13, and the second transmission structure_2 (B2) of the fourth memory chip 14 are aligned along the third direction and connected to form a signal transmission channel;
(3) the fourth transmission structure_1 (D1) of the logic chip 50, the second transmission structure_2 (B2) of the first memory chip 11, the second transmission structure_3 (B3) of the second memory chip 12, the second transmission structure_0 (B0) of the third memory chip 13, and the second transmission structure_1 (B1) of the fourth memory chip 14 are aligned along the third direction and connected to form a signal transmission channel;
(4) the fourth transmission structure_0 (D0) of the logic chip 50, the second transmission structure_3 (B3) of the first memory chip 11, the second transmission structure_2 (B2) of the second memory chip 12, the second transmission structure_1 (B1) of the third memory chip 13, and the second transmission structure _0 (B0) of the fourth memory chip 14 are aligned along the third direction and connected to form a signal transmission channel;
(5) the fourth transmission structure_4 (D4) of the logic chip 50, the second transmission structure_4 (B4) of the first memory chip 11, the second transmission structure_5 (B5) of the second memory chip 12, the second transmission structure_6 (B6) of the third memory chip 13, and the second transmission structure_7 (B7) of the fourth memory chip 14 are aligned along the third direction and connected to form a signal transmission channel;
(6) the fourth transmission structure_5 (D5) of the logic chip 50, the second transmission structure _5 (B5) of the first memory chip 11, the second transmission structure_4 (B4) of the second memory chip 12, the second transmission structure_7 (B7) of the third memory chip 13, and the second transmission structure _6 (B6) of the fourth memory chip 14 are aligned along the third direction and connected to form a signal transmission channel;
(7) the fourth transmission structure_6 (D6) of the logic chip 50, the second transmission structure _6 (B6) of the first memory chip 11, the second transmission structure_7 (B7) of the second memory chip 12, the second transmission structure_4 (B4) of the third memory chip 13, and the second transmission structure_5 (B5) of the fourth memory chip 14 are aligned along the third direction and connected to form a signal transmission channel;
(8) the fourth transmission structure_7 (D7) of the logic chip 50, the second transmission structure _7 (B7) of the first memory chip 11, the second transmission structure_6 (B6) of the second memory chip 12, the second transmission structure_5 (B5) of the third memory chip 13, and the second transmission structure_4 (B4) of the fourth memory chip 14 are aligned along the third direction and connected to form a signal transmission channel.

It should be noted that the second transmission structure_0 (B0), the second transmission structure _1 (B1), the second transmission structure_2 (B2), and the second transmission structure_3 (B3) are all used for transmitting the second identification signal signalB<0>, and four signalB<0>(s) are subjected to an OR logic to generate an SID<0>, and the second transmission structure_4 (B4), the second transmission structure_5 (B5), the second transmission structure_6 (B6), and the second transmission structure_7 (B7) are all used for transmitting the second identification signal signalB<1>, and four signalB<1>(s) are subjected to an OR logic to generate an SID<1>.

It should be noted that in some operation scenarios, the diagonal stripe pillars between the chips in FIG. 14A and FIG. 14B may be conductive bumps, hybrid bonding structures, or the like, or as another understanding, FIG. 14A and FIG. 14B are intended to emphasize the alignment relationship along the third direction of the signal zones, the conductive vias, and the like, but do not represent the physical structure thereof, which is not specifically limited here.

In particular, FIG. 14A and FIG. 14B are both illustrated with the first axis AA' as the boundary of the high-bit transmission region and the low-bit transmission region; at this time, the orientations (i.e., the high-bit transmission regions) of the logic chip 50, the first transmission chip 11, and the fourth transmission chip 14 are the same (which does not mean that the high-bit transmission regions of these chips completely coincide, and there may be a mirror image relationship along the horizontal direction); the orientations (i.e., the high-bit transmission regions) of the second transmission chip 12 and the third transmission chip 13 are the same.

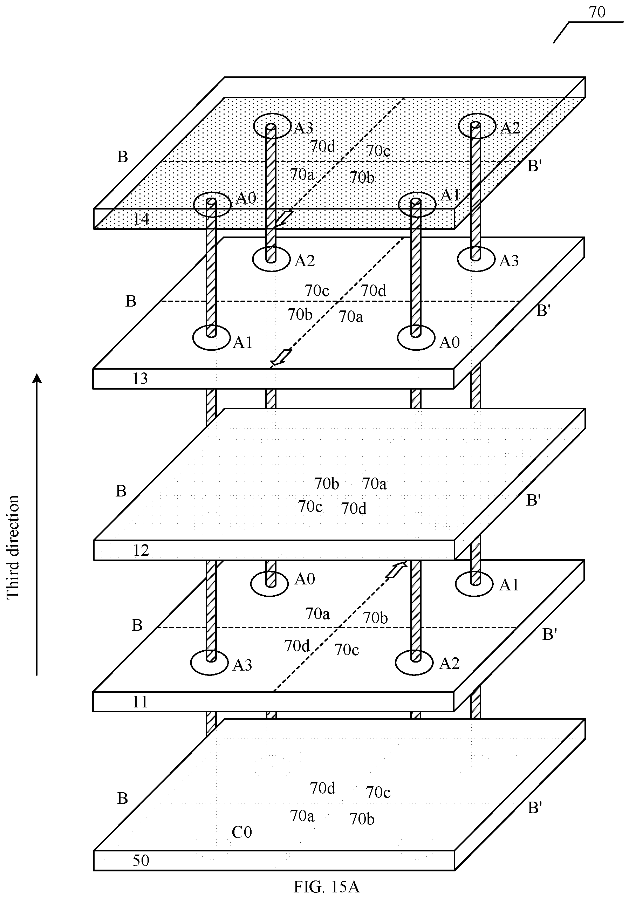

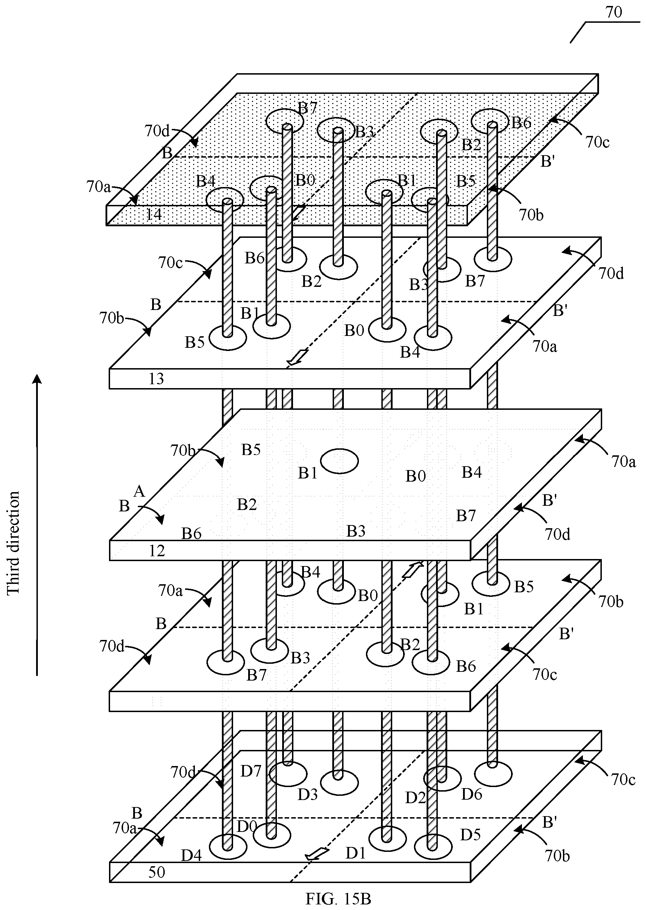

In other embodiments, the second axis BB' may also be used as a boundary between the high-bit transmission region and the low-bit transmission region, and in this case, the alignment relationship of the first transmission structures and the third transmission structures is as shown in FIG. 15A, and the alignment relationship of the second transmission structures and the fourth transmission structures is as shown in FIG. 15B. At this time, the orientations (i.e., the high-bit transmission regions) of the logic chip 50, the third transmission chip 13, and the fourth transmission chip 14 are the same (which does not mean that the high-bit transmission regions of these chips completely coincide); the orientations (i.e., the high-bit transmission regions) of the first transmission chip 11 and the second transmission chip 12 are the same.

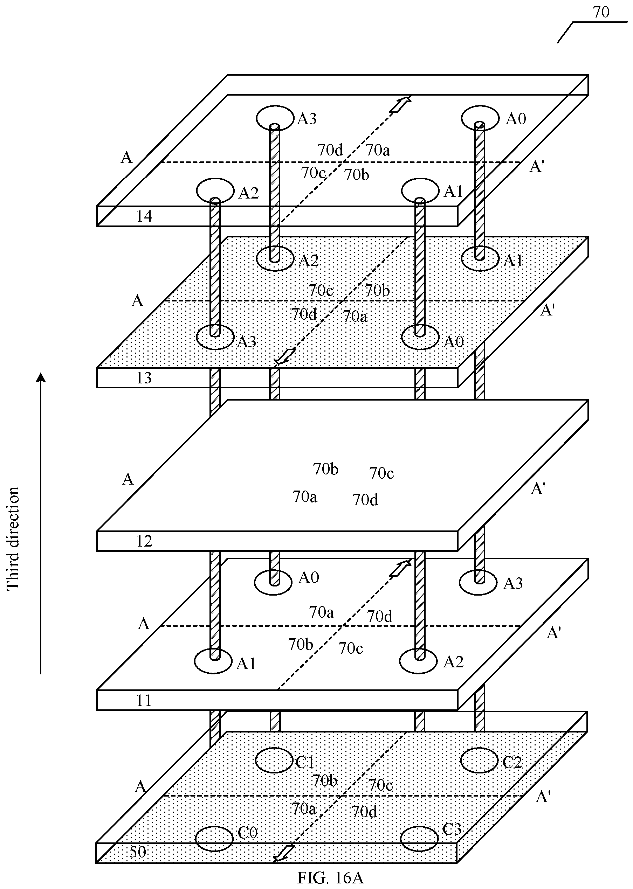

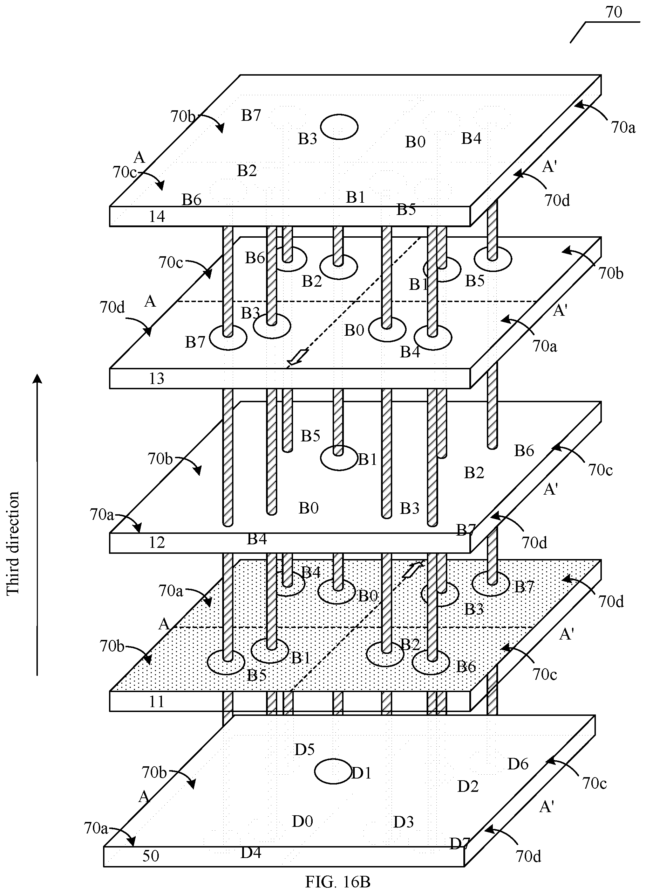

In still other embodiments, referring to FIG. 16A and FIG. 16B, in the case that the logic chip 50 and the first memory chip 11 are stacked in a back-to-back manner,
(1) the second signal zone 70b of the logic chip 50, the first signal zone 70a of the first memory chip 11, the second signal zone 70b of the second memory chip 12, the third signal zone 70c of the third memory chip 13, and the fourth signal zone 70d of the fourth memory chip 14 are aligned along the third direction;
(2) the first signal zone 70a of the logic chip 50, the second signal zone 70b of the first memory chip 11, the first signal zone 70a of the second memory chip 12, the fourth signal zone 70d of the third memory chip 13, and the third signal zone 70c of the fourth memory chip 14 are aligned along the third direction;
(3) the fourth signal zone 70d of the logic chip 50, the third signal zone 70c of the first memory chip 11, the fourth signal zone 70d of the second memory chip 12, the first signal zone 70a of the third memory chip 13, and the second signal zone 70b of the fourth memory chip 14 are aligned along the third direction;
(4) the third signal zone 70c of the logic chip 50, the fourth signal zone 70d of the first memory chip 11, the third signal zone 70c of the second memory chip 12, the second signal zone 70b of the third memory chip 13, and the first signal zone 70a of the fourth memory chip 14 are aligned along the third direction.

In short, the way in which the logic chip 50 is arranged at this time is the same as that of the second memory chip 12.

Referring to FIG. 16A, the alignment of the third transmission structures and the first transmission structures is as follows:
(1) the third transmission structure_1 (C1) of the logic chip 50, the first transmission structure _0 (A0) of the first memory chip 11, the first transmission structure_1 (A1) of the second memory chip 12, the first transmission structure_2 (A2) of the third memory chip 13, and the first transmission structure_3 (A3) of the fourth memory chip 14 are aligned along the third direction and connected to form a signal transmission channel;
(2) the third transmission structure_0 (C0) of the logic chip 50, the first transmission structure_1 (A1) of the first memory chip 11, the first transmission structure_0 (A0) of the second memory chip 12, the first transmission structure _3 (A3) of the third memory chip 13, and the first transmission structure_2 (A2) of the fourth memory chip 14 are aligned along the third direction and connected to form a signal transmission channel;
(3) the third transmission structure _3 (C3) of the logic chip 50, the first transmission structure_2 (A2) of the first memory chip 11, the first transmission structure_3 (A3) of the second memory chip 12, the first transmission structure_0 (A0) of the third memory chip 13, and the first transmission structure_1 (A1) of the fourth memory chip 14 are aligned along the third direction and connected to form a signal transmission channel;
(4) the third transmission structure_2 (C2) of the logic chip 50, the first transmission structure_3 (A3) of the first memory chip 11, the first transmission structure_2 (A2) of the second memory chip 12, the first transmission structure_1 (A1) of the third memory chip 13, and the first transmission structure _0 (A0) of the fourth memory chip 14 are aligned along the third direction and connected to form a signal transmission channel.

Referring to FIG. 16B, the alignment of the fourth transmission structures and the second transmission structures is as follows:
(1) the fourth transmission structure_1 (D1) of the logic chip 50, the second transmission structure_0 (B0) of the first memory chip 11, the second transmission structure_1 (B1) of the second memory chip 12, the second transmission structure_2 (B2) of the third memory chip 13, and the second transmission structure_3 (B3) of the fourth memory chip 14 are aligned along the third direction and connected to form a signal transmission channel;
(2) the fourth transmission structure_2 (D2) of the logic chip 50, the second transmission structure _1 (B1) of the first memory chip 11, the second transmission structure_0 (B0) of the second memory chip 12, the second transmission structure_3 (B3) of the third memory chip 13, and the second transmission structure_2 (B2) of the fourth memory chip 14 are aligned along the third direction and connected to form a signal transmission channel;
(3) the fourth transmission structure_0 (D0) of the logic chip 50, the second transmission structure_2 (B2) of the first memory chip 11, the second transmission structure_3 (B3) of the second memory chip 12, the second transmission structure_0 (B0) of the third memory chip 13, and the second transmission structure_1 (B1) of the fourth memory chip 14 are aligned along the third direction and connected to form a signal transmission channel;
(4) the fourth transmission structure_3 (D3) of the logic chip 50, the second transmission structure_3 (B3) of the first memory chip 11, the second transmission structure_2 (B2) of the second memory chip 12, the second transmission structure_1 (B1) of the third memory chip 13, and the second transmission structure _0 (B0) of the fourth memory chip 14 are aligned along the third direction and connected to form a signal transmission channel;
(5) the fourth transmission structure_2 (D2) of the logic chip 50, the second transmission structure_4 (B4) of the first memory chip 11, the second transmission structure_5 (B5) of the second memory chip 12, the second transmission structure_6 (B6) of the third memory chip 13, and the second transmission structure_7 (B7) of the fourth memory chip 14 are aligned along the third direction and connected to form a signal transmission channel;
(6) the fourth transmission structure_5 (D5) of the logic chip 50, the second transmission structure_5 (B5) of the first memory chip 11, the second transmission structure_4 (B4) of the second memory chip 12, the second transmission structure_7 (B7) of the third memory chip 13, and the second transmission structure _6 (B6) of the fourth memory chip 14 are aligned along the third direction and connected to form a signal transmission channel;
(7) the fourth transmission structure_6 (D6) of the logic chip 50, the second transmission structure_6 (B6) of the first memory chip 11, the second transmission structure_7 (B7) of the second memory chip 12, the second transmission structure_4 (B4) of the third memory chip 13, and the second transmission structure_5 (B5) of the fourth memory chip 14 are aligned along the third direction and connected to form a signal transmission channel;
(8) the fourth transmission structure_7 (D7) of the logic chip 50, the second transmission structure_7 (B7) of the first memory chip 11, the second transmission structure_6 (B6) of the second memory chip 12, the second transmission structure_5 (B5) of the third memory chip 13, and the second transmission structure_4 (B4) of the fourth memory chip 14 are aligned along the third direction and connected to form a signal transmission channel.

In particular, FIG. 16A and FIG. 16B are both illustrated with the first axis AA' as the boundary of the high-bit transmission region and the low-bit transmission region; at this time, the orientations (i.e., the high-bit transmission regions) of the logic chip 50, the second transmission chip 12, and the third transmission chip 13 are the same (which does not mean that the high-bit transmission regions of these chips completely coincide); the orientations (i.e., the high-bit transmission regions) of the first transmission chip 11 and the fourth transmission chip 14 are the same.

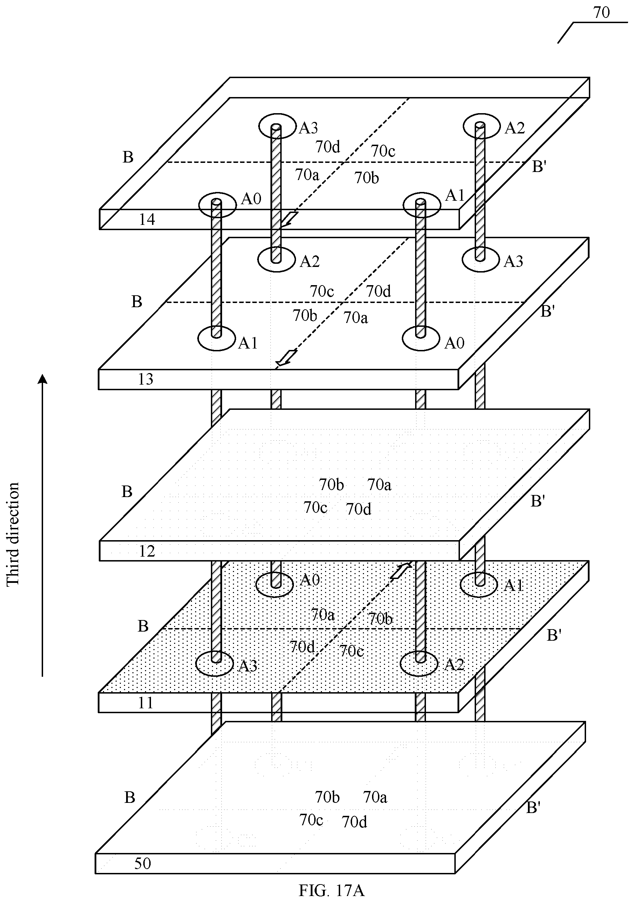

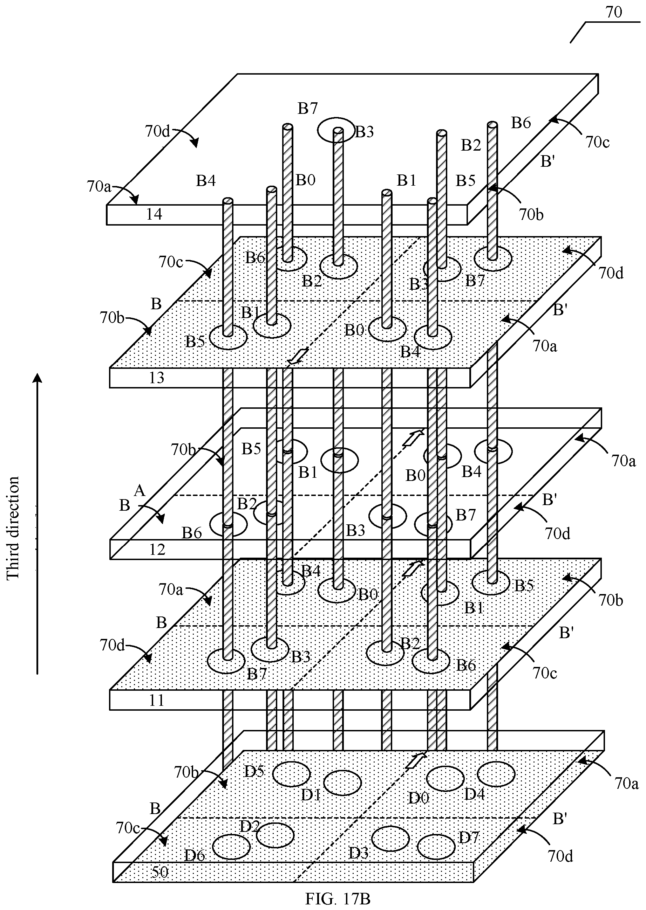

In other embodiments, the second axis BB' may also be used as a boundary between the high-bit transmission region and the low-bit transmission region, and in this case, the alignment relationship of the first transmission structures and the third transmission structures is as shown in FIG. 17A, and the alignment relationship of the second transmission structures and the fourth transmission structures is as shown in FIG. 17B. At this time, the orientations (i.e., the high-bit transmission regions) of the logic chip 50, the first transmission chip 11, and the second transmission chip 12 are the same (which does not mean that the high-bit transmission regions of these chips completely coincide); the orientations (i.e., the high-bit transmission regions) of the third transmission chip 13 and the fourth transmission chip 14 are the same.

As can be seen from the above, for the chip stack structure 70, the transmission structure along the third direction is different in different chips. Specifically, from a physical perspective, the conductive vias therein are still in a direct connection configuration, but from a perspective of absolute positions of the conductive vias, the conductive vias therein can be regarded as in a functionally rotational configuration, that is, a signal transmission effect similar to that of FIG. 2B is achieved through the physical direct connection configuration (i.e., a rotation-type transmission, such as the transmission structure _0-the transmission structure _1-the transmission structure _2-the transmission structure_3, ...). In short, the chip stack structure in FIG. 2B needs a physical spiral structure, in which a lateral interconnection structure is necessarily present, whereas the chip stack structure of FIG. 14A to FIG. 17B is a physical direct connection structure and does not need a lateral interconnection structure, such that the parasitic resistance is greatly reduced, and the transmission speed and the transmission performance are greatly improved.

Based on the aforementioned operation principle of the comparison circuit, the logic processing circuit, and the logic operation circuit in each memory chip, the transmission principle of SID and CID in the chip stack structure 70 is as follows:
referring to Table 3, in the normal operation process, after the initially combined signalA<3:0> is generated by the logic chip and then transmitted via the third transmission structures and the first transmission structures: the signalA<3:0> received by the memory chip 0 and the memory chip 4 is 0001, which is decoded to obtain CID<1:0> = 00, which represents that the memory chip is the 0^{th} memory chip in the stack unit to which it belongs; the signalA<3:0> received by the memory chip 1 and the memory chip 5 is 0010, which is decoded to obtain CID<1:0> = 01, which represents that the memory chip is the first memory chip in the stack unit to which it belongs; the signalA<3:0> received by the memory chip 2 and the memory chip 6 is 0100, which is decoded to obtain CID<1:0> = 10, which represents that the memory chip is the second memory chip in the stack unit to which it belongs; the signalA<3:0> received by the memory chip 3 and the memory chip 7 is 1000, which is decoded to obtain CID<1:0> = 11, which represents that the memory chip is the third memory chip in the stack unit to which it belongs (i.e., the last memory chip in the stack unit). Meanwhile, the SID is transmitted from bottom to top, and the second signal generating circuit in the logic chip 50 enables its SID<1:0> to be 00; when the SID<1:0> is transmitted to the memory chip 3 upwards, since the memory chip 3 is the last one chip of the stack unit, the memory chip 3 performs a plus-one operation on the SID<1:0> and transmits it to the memory chip 4, and the SID<1:0> received by the memory chip 4 is 01, so that the SID<1:0> of the memory chip 0 to the memory chip 3 is 00, but the SID<1:0> of the memory chip 4 to the memory chip 7 is 01.

Referring to Table 4, in the initialization process, after the initially combined signalA<3:0> is generated by the logic chip and then transmitted via the third transmission structures and the first transmission structures: the signalA<3:0> received by the memory chip 0 and the memory chip 4 is 1000, which is decoded to obtain CID<1:0> = 11, which represents that the memory chip is the third memory chip in the stack unit to which it belongs; the signalA<3:0> received by the memory chip 1 and the memory chip 5 is 0100, which is decoded to obtain CID<1:0> = 10, which represents that the memory chip is the second memory chip in the stack unit to which it belongs; the signalA<3:0> received by the memory chip 2 and the memory chip 6 is 0010, which is decoded to obtain CID<1:0> = 01, which represents that the memory chip is the first memory chip in the stack unit to which it belongs; the signalA<3:0> received by the memory chip 3 and the memory chip 7 is 0001, which is decoded to obtain CID<1:0> = 00, which represents that the memory chip is the 0^{th} memory chip in the stack unit to which it belongs. Meanwhile, the SID is transmitted from top to bottom, and the weak driving circuit in the logic chip 7 enables its SID<1:0> to be 00; when the SID<1:0> is transmitted to the memory chip 4 downwards, since the memory chip 4 is the last one chip of the stack unit, the memory chip 4 performs a plus-one operation on the SID<1:0> and transmits it to the memory chip 3, and the SID<1:0> received by the memory chip 3 is 01, so that the SID<1:0> of the memory chip 0 to the memory chip 3 is 01, but the SID<1:0> of the memory chip 4 to the memory chip 7 is 00.

**Table 3**

| | signal A<0> | signal A<1> | signal A<2> | signal A<3> | CID <1:0> | SID <1:0> |
|---|---|---|---|---|---|---|
| Memory chip 7 | 0 | 0 | 0 | 1 | 11 | 01 |
| Memory chip 6 | 0 | 0 | 1 | 0 | 10 | 01 |
| Memory chip 5 | 0 | 1 | 0 | 0 | 01 | 01 |
| Memory chip 4 | 1 | 0 | 0 | 0 | 00 | 01 |
| Memory chip 3 | 0 | 0 | 0 | 1 | 11 | 00 |
| Memory chip 2 | 0 | 0 | 1 | 0 | 10 | 00 |
| Memory chip 1 | 0 | 1 | 0 | 0 | 01 | 00 |
| Memory chip 0 | 1 | 0 | 0 | 0 | 00 | 00 |
| Logic chip | 1 | 0 | 0 | 0 | 00 | 00 |

**Table 4**

| | signal A<0> | signal A<1> | signal A<2> | signal A<3> | CID <1:0> | SID <1:0> |
|---|---|---|---|---|---|---|
| Memory chip 7 | 1 | 0 | 0 | 0 | 00 | 00 |
| Memory chip 6 | 0 | 1 | 0 | 0 | 01 | 00 |
| Memory chip 5 | 0 | 0 | 1 | 0 | 10 | 00 |
| Memory chip 4 | 0 | 0 | 0 | 1 | 11 | 00 |
| Memory chip 3 | 1 | 0 | 0 | 0 | 00 | 01 |
| Memory chip 2 | 0 | 1 | 0 | 0 | 01 | 01 |
| Memory chip 1 | 0 | 0 | 1 | 0 | 10 | 01 |
| Memory chip 0 | 0 | 0 | 0 | 1 | 11 | 01 |
| Logic chip | 0 | 0 | 0 | 1 | 11 | 10 |

From the above, it can be seen that for the chip stack structure 70 provided according to an embodiment of the present disclosure, the transmission structures therein have four-quadrant symmetry (arranged symmetrically about the first axis and about the second axis) and can be directly applied to a face-to-face stack structure, a back-to-back stack structure, or a back-to-face stack structure; the chip stack structure has the following advantages: (1) the transmission of the chip position identification code CID can be achieved by only using four first transmission structures without respectively arranging four first transmission structures for each memory chip; in short, for the chip stack structure formed by eight memory chips and a logic chip, only four first transmission structures need to be arranged, and thus the number of the first transmission structures is small, and the chip area and the cost can be saved; (2) the transmission of the stack position identification code SID is performed through a second transmission structure formed by the conductive via and the contact structure together, and the last one memory chip is subjected to a plus-one operation, so that the transmission can be achieved only by two second transmission structure groups (i.e., eight second transmission structures), and thus the number of the second transmission structures is small, and the chip area and the cost are saved; (3) the second transmission structure can enable transmission from top to bottom or from bottom to top, so that transmission logic can be well achieved in the case of face-to-face stacking, and two numbering mechanisms in an initialization process and a normal operation process are supported; (4) the second transmission structure group transmits one bit of the stack position identification code SID together, so that correct transmission can still be ensured when part of the second transmission structures fail, and the failure handling performance is improved. In addition, compared with the memory chip 10 in FIG. 2A, the chip stack structure formed by the memory chip 10 reduces the parasitic capacitance, which not only saves the circuit area, but also reduces the chip manufacturing cost; the chip stack structure formed by the memory chip 10 also reduces parasitic resistance compared with the memory chip 10 in FIG. 2B (for a specific reason, see the following description).

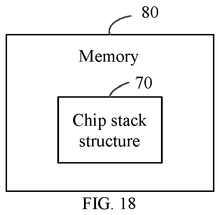

In still another embodiment of the present disclosure, referring to FIG. 18, a schematic diagram of a composition structure of a memory 80 provided according to an embodiment of the present disclosure is shown. As shown in FIG. 18, the memory 80 includes at least the chip stack structure 70 described above. The memory 80 may be, for example, a static random access memory (SRAM), a dynamic random access memory (DRAM), a synchronous dynamic random access memory (SDRAM), a double data rate SDRAM (DDR SDRAM), or the like, which is not specifically limited herein.

The above description shows merely preferred embodiments of the present disclosure and is not intended to limit the protection scope of the present disclosure. It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a ..." or "comprising a ..." does not exclude the presence of other identical elements in the process, method, item, or apparatus that includes the element. The serial numbers of the embodiments of the present disclosure described above are for the purpose of describing only and do not represent the superiority or inferiority of the embodiments. The methods disclosed in the method embodiments provided in the present disclosure may be combined in any manner without conflict to obtain new method embodiments. The features disclosed in the product embodiments provided in the present disclosure may be combined in any manner without conflict to obtain new product embodiments. The features disclosed in the method or device embodiments provided in the present disclosure may be combined in any manner without conflict to obtain new method or device embodiments. The above is only the specific embodiments of the present disclosure, but the protection scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A memory chip (10), wherein a top surface of the memory chip (10) has a first axis and a second axis, the first axis and the second axis are perpendicular to each other and intersect at a center of the top surface, the first axis is parallel to one edge of the top surface, and the second axis is parallel to the other edge of the top surface;
the memory chip (10) comprises four first transmission structures and B second transmission structure groups, wherein B is a natural number;
the four first transmission structures are arranged symmetrically about the first axis, and the four first transmission structures are arranged symmetrically about the second axis;
each one of the second transmission structure groups comprises four second transmission structures, and the four second transmission structures are arranged symmetrically about the first axis, and the four second transmission structures are arranged symmetrically about the second axis;
the memory chip (10) receives one first identification signal from each one of the first transmission structures and generates a chip position identification code based on four first identification signals; signal levels transmitted by the four second transmission structures in a same one of the second transmission structure groups are the same, and the memory chip (10) receives one second identification signal from each one of the second transmission structure groups and generates a stack position identification code based on B second identification signals;
wherein the memory chip (10) determines a position number thereof in a chip stack structure (70) to which the memory chip belongs according to the stack position identification code and the chip position identification code.

2. The memory chip (10) according to claim 1, wherein the memory chip (10) further comprises four first driving circuits (21) and a first decoding circuit (22), and the four first driving circuits (21) are coupled to the four first transmission structures in a one-to-one correspondence;
the first decoding circuit (22) is coupled to the four first driving circuits (21) and is configured to receive the four first identification signals via the four first driving circuits (21) and decode the four first identification signals received to generate the chip position identification code;
wherein four memory chips (10) are stacked to form a stack unit, and the chip position identification code indicates a position number of the memory chip (10) in the stack unit to which the memory chip belongs.

3. The memory chip (10) according to claim 2, wherein the memory chip (10) further comprises a comparison circuit (31), a logic processing circuit (32), and a logic operation circuit (33);
the comparison circuit (31) is coupled to the first decoding circuit (22) and is configured to generate an effective first control signal when the chip position identification code is the same as a preset chip position identifier, wherein the preset chip position identifier indicates that the memory chip (10) is the last one chip in the stack unit to which the memory chip belongs;
the logic processing circuit (32) is coupled to the B second transmission structure groups and is configured to receive one second identification signal from each one of the second transmission structure groups and generate the stack position identification code based on the B second identification signals received, wherein a plurality of stack units are stacked to form the chip stack structure (70), and the stack position identification code indicates a position number of the stack unit to which the memory chip (10) belongs in the chip stack structure (70) to which the stack unit belongs;
the logic operation circuit (33) is coupled to the comparison circuit (31) and the logic processing circuit (32) and is configured to receive the first control signal and the stack position identification code and perform a plus-one operation on the stack position identification code to generate and output the second identification signal of a next memory chip (10) when the first control signal is effective and output the stack position identification code of the memory chip (10) as the second identification signal of the next memory chip (10) when the first control signal is ineffective;
the logic processing circuit (32) is further configured to receive the second identification signal of the next memory chip (10) output by the logic operation circuit (33) and transmit the second identification signal to a next memory chip (10) through the B second transmission structure groups; wherein an i^{th} one of the second identification signals of the next memory chip (10) is transmitted to the next memory chip (10) through an i^{th} one of the second transmission structure groups, wherein i is a natural number less than or equal to B.

4. The memory chip (10) according to claim 3, wherein each one of the second transmission structures has a conductive via and a contact structure spaced apart along a third direction, the conductive via penetrates through a substrate of the memory chip (10) along the third direction, and the contact structure penetrates through the top surface;
the logic processing circuit (32) comprises B second driving circuits (321) and B third driving circuits (322);
an i^{th} one of the second driving circuits (321) is coupled to the conductive via of each one of the second transmission structures in the i^{th} one of the second transmission structure groups; the i^{th} one of the second driving circuits (321) is further coupled to the logic operation circuit (33); i is a natural number and is less than or equal to B;
an i^{th} one of the third driving circuits (322) is coupled to the contact structure of each one of the second transmission structures in the i^{th} second transmission structure group; the i^{th} one of the third driving circuits (322) is further coupled to the logic operation circuit (33).

5. The memory chip (10) according to claim 4, wherein
the logic processing circuit (32) is further coupled to the first decoding circuit (22) and is configured to: receive the chip position identification code; in a case that the chip position identification code indicates that the memory chip (10) is at an even-numbered position, receive the second identification signal of the memory chip from the conductive via of each one of the second transmission structures in a corresponding second transmission structure group via the second driving circuit (321) and send the generated stack position identification code to the logic operation circuit (33); and send the second identification signal of the next memory chip (10) output by the logic operation circuit (33) to the contact structure of each one of the second transmission structures in the corresponding second transmission structure group via the third driving circuit (322);
or in a case that the chip position identification code indicates that the memory chip (10) is at an odd-numbered position, receive the second identification signal of the memory chip from the contact structure of each one of the second transmission structures in a corresponding second transmission structure group via the third driving circuit (322), send the generated stack position identification code to the logic operation circuit (33), and send the second identification signal of the next memory chip (10) output by the logic operation circuit (33) to the conductive via of each one of the second transmission structures in the corresponding second transmission structure group via the second driving circuit (321).

6. The memory chip (10) according to claim 5, wherein the second driving circuit (321) comprises a first OR logic circuit (41), an even driving input circuit (42), and an odd driving output circuit (43); an input end of the first OR logic circuit (41) is coupled to the conductive via of each one of the second transmission structures in a corresponding second transmission structure group, the even driving input circuit (42) is coupled between an output end of the first OR logic circuit (41) and an input end of the logic operation circuit (33), and the odd driving output circuit (43) is coupled between an output end of the logic operation circuit (33) and the conductive via of each one of the second transmission structures in a corresponding second transmission structure group;
the third driving circuit (322) comprises a second OR logic circuit (44), an even driving output circuit (46) and an odd driving input circuit (45); an input end of the second OR logic circuit (44) is coupled to the contact structure of each one of the second transmission structures of a corresponding second transmission structure group, the odd driving input circuit (45) is coupled between an output end of the second OR logic circuit (44) and the input end of the logic operation circuit (33), the even driving output circuit (46) is coupled between the output end of the logic operation circuit (33) and the contact structure of each one of the second transmission structures of the corresponding second transmission structure group;
wherein a control end of the odd driving input circuit (45) and a control end of the odd driving output circuit (43) both receive a first odd switching signal; a control end of the even driving input circuit (42) and a control end of the even driving output circuit (46) both receive a first even switching signal; if the chip position identification code indicates that the memory chip (10) is in an odd-numbered position, the first odd switching signal is in an enabled state, and the first even switching signal is in a disabled state; if the chip position identification code indicates that the memory chip (10) is in an even-numbered position, the first odd switching signal is in a disabled state, and the first even switching signal is in an enabled state.

7. The memory chip (10) according to claim 6, wherein the logic operation circuit (33) comprises an adder (331) and a select circuit (332);
the adder (331) is configured to perform a plus-one operation on the stack position identification code and output a stack code carry signal;
the select circuit (332) is configured to output the stack code carry signal as the second identification signal of the next memory chip (10) if the first control signal is effective and directly output the stack position identification code as the second identification signal of the next memory chip (10) if the first control signal is ineffective.

8. The memory chip (10) according to claim 7, wherein the logic processing circuit (32) further comprises a weak driving circuit;
the logic processing circuit (32) is further configured to generate the second identification signal of a default state based on the weak driving circuit if the second transmission structure does not transmit an effective signal; and generate the second identification signal based on an effective signal transmitted by the second transmission structure if the second transmission structure transmits the effective signal.

9. The memory chip (10) according to claim 8, wherein the weak driving circuit comprises B first logic devices (323) and B second logic devices (324);
each one of the odd driving input circuits (45) is coupled to one of the first logic devices (323); the odd driving input circuit (45) comprises a first inverting driving unit (451) and a second inverting driving unit (452), the output end of the second OR logic circuit (44) is connected to an input end of the first inverting driving unit (451), an output end of the first inverting driving unit (451) is connected to an input end of the second inverting driving unit (452), an output end of the second inverting driving unit (452) is connected to the input end of the logic operation circuit (33), and a control end of the first inverting driving unit (451) and a control end of the second inverting driving unit (452) both receive the first odd switching signal; an output end of the first logic device (323) is connected to the input end of the first inverting driving unit (451), a first input end of the first logic device (323) receives a power-on indication signal, and a second input end of the first logic device (323) is connected to the output end of the first inverting driving unit (451);
each one of the even driving input circuits (42) is coupled to one of the second logic devices (324); the even driving input circuit (42) comprises a third inverting driving unit (421) and a fourth inverting driving unit (422), the output end of the first OR logic circuit (41) is connected to an input end of the third inverting driving unit (421), an output end of the third inverting driving unit (421) is connected to an input end of the fourth inverting driving unit (422), an output end of the fourth inverting driving unit (422) is connected to the input end of the logic operation circuit (33), and a control end of the third inverting driving unit (421) and a control end of the fourth inverting driving unit (422) both receive the first even switching signal; an output end of the second logic device (324) is connected to the input end of the third inverting driving unit (421), a first input end of the second logic device (324) receives a power-on indication signal, and a second input end of the second logic device (324) is connected to the output end of the third inverting driving unit (421).

10. The memory chip (10) according to claim 9, wherein the first logic device (323) and the second logic device (324) are both two-input NOR gates; after the memory chip (10) is powered on, the power-on indication signal is a high level; the second identification signal of a default state is a low level;
the first transmission structure is manufactured by any one or more of a via-first process, a via-middle process, a via-last process, and a back side via-last process; the conductive via in the second transmission structure is manufactured by any one or more of a via-first process and a via-middle process; different first transmission structures are electrically isolated from each other and different second transmission structures are also electrically isolated from each other.

11. A logic chip (50), wherein a top surface of the logic chip (50) has a first axis and a second axis, the first axis and the second axis are perpendicular to each other and intersect at a center of the top surface, the first axis is parallel to one edge of the top surface, and the second axis is parallel to the other edge of the top surface;
the logic chip (50) comprises four third transmission structures and B fourth transmission structure groups, wherein B is a natural number;
the four third transmission structures are arranged symmetrically about the first axis and the four third transmission structures are arranged symmetrically about the second axis; each one of the fourth transmission structure groups comprises four fourth transmission structures, and the four fourth transmission structures are arranged symmetrically about the first axis, and the four fourth transmission structures are arranged symmetrically about the second axis;
the logic chip (50) is configured to generate four first identification signals and transmit the four first identification signals to the four third transmission structures in a one-to-one correspondence, wherein the four first identification signals indicate a chip position identification code of a memory chip (10) adjacent to the logic chip (50);
the logic chip (50) is further configured to receive one second identification signal from each one of the fourth transmission structure groups and generate a stack position identification code based on B second identification signals in an initialization process; or generate B second identification signals of a default state and send one of the second identification signals to one of the fourth transmission structure groups in a normal operation stage.

12. The logic chip (50) according to claim 11, wherein the logic chip (50) further comprises a first signal generating circuit (52) and four fourth driving circuits (51), and the four fourth driving circuits (51) are coupled to the four third transmission structures in a one-to-one correspondence;
the first signal generating circuit (52) is coupled to the four fourth driving circuits (51) and is configured to: generate four first identification signals in the initialization process, wherein level states of the four first identification signals are a first combination value; and generate four first identification signals in the normal operation process, wherein level states of the four first identification signals are a second combination value;
wherein the first combination value and the second combination value are not completely identical.

13. The logic chip (50) according to claim 12, wherein the logic chip (50) further comprises a second signal generating circuit (64), B third OR logic circuits (61), B control input circuits (62), and B control output circuits (63);
the second signal generating circuit (64) is coupled to the B control output circuits (63) and is configured to generate B second identification signals of a default state in the normal operation stage and transmit an i^{th} one of the second identification signals to an input end of an i^{th} one of the control output circuits (63) in a one-to-one correspondence, wherein an output end of the i^{th} one of the control output circuits (63) is coupled to each one of the fourth transmission structures in an i^{th} one of the fourth transmission structure groups; i is a natural number less than or equal to B;
each one of the fourth transmission structures in the i^{th} one of the fourth transmission structure groups is coupled to an input end of an i^{th} one of the third OR logic circuits (61), an output end of the third OR logic circuit (61) is coupled to the input end of the i^{th} one of the control output circuits (63), and the output end of the i^{th} one of the control input circuits (62) is coupled to an internal circuit of the logic chip (50);
in the initialization process, the output end of the i^{th} one of the control input circuits (62) outputs the i^{th} one of the second identification signals to the internal circuit of the logic chip (50);
wherein control ends of the control output circuits (63) all receive an output enabled signal, and control ends of the control input circuits (62) all receive an input enabled signal; if the logic chip (50) is in the normal operation stage, the input enabled signal is in a disabled state, and the output enabled signal is in an enabled state; if the logic chip (50) is in the initialization process, the input enabled signal is in an enabled state, and the output enabled signal is in a disabled state.

14. The logic chip (50) according to any one of claims 11 to 13, wherein
the third transmission structure or the fourth transmission structure is manufactured by any one or more of a via-first process, a via-middle process, a via-last process, and a back side via-last process; different third transmission structures are electrically isolated from each other and different fourth transmission structures are also electrically isolated from each other.

15. A chip stack structure (70), comprising the logic chip (50) according to any one of claims 11 to 14 and at least one stack unit, wherein the logic chip (50) and the at least one stack unit are sequentially stacked along a third direction; each one of the at least one stack unit comprises a first memory chip (11), a second memory chip (12), a third memory chip (13), and a fourth memory chip (14) sequentially stacked along the third direction, and the third direction is perpendicular to a top surface of each one of the memory chips (10); the first memory chip (11), the second memory chip (12), the third memory chip (13) and the fourth memory chip (14) are each the memory chip (10) according to any one of claims 1 to 10;
the first memory chip (11) and the second memory chip (12) are stacked in a face-to-face manner, the second memory chip (12) and the third memory chip (13) are stacked in a back-to-back manner, and the third memory chip (13) and the fourth memory chip (14) are stacked in a face-to-face manner; the logic chip (50) and the first memory chip (11) are stacked in a back-to-back manner; or the logic chip (50) and the first memory chip (11) are stacked in a face-to-back manner.

16. The chip stack structure (70) according to claim 15, wherein a top surface of the logic chip (50) or each one of the memory chips (10) is divided into 2×2 signal zones; a first signal zone (70a) and a second signal zone (70b) are arranged symmetrically along a first axis thereof, the first signal zone (70a) and a fourth signal zone (70d) are arranged symmetrically along a second axis thereof, a third signal zone (70c) and the fourth signal zone (70d) are arranged symmetrically along a first axis thereof; the first axes of the logic chip (50) and each one of the memory chips (10) are aligned along the third direction, and the second axes of the logic chip (50) and each one of the memory chips (10) are aligned along the third direction;
in a case that the logic chip (50) and the first memory chip (11) are stacked in a back-to-back manner, the fourth signal zone (70d) of the logic chip (50), the first signal zone (70a) of the first memory chip (11), the second signal zone (70b) of the second memory chip (12), the third signal zone (70c) of the third memory chip (13), and the fourth signal zone (70d) of the fourth memory chip (14) are aligned along the third direction;
the third signal zone (70c) of the logic chip (50), the second signal zone (70b) of the first memory chip (11), the first signal zone (70a) of the second memory chip (12), the fourth signal zone (70d) of the third memory chip (13), and the third signal zone (70c) of the fourth memory chip (14) are aligned along the third direction;
the second signal zone (70b) of the logic chip (50), the third signal zone (70c) of the first memory chip (11), the fourth signal zone (70d) of the second memory chip (12), the first signal zone (70a) of the third memory chip (13), and the second signal zone (70b) of the fourth memory chip (14) are aligned along the third direction;
the first signal zone (70a) of the logic chip (50), the fourth signal zone (70d) of the first memory chip (11), the third signal zone (70c) of the second memory chip (12), the second signal zone (70b) of the third memory chip (13), and the first signal zone (70a) of the fourth memory chip (14) are aligned along the third direction.

17. The chip stack structure (70) according to claim 16, wherein for four first transmission structures in each one of the memory chips (10), a first transmission structure_0, a first transmission structure_1, a first transmission structure_2, and a first transmission structure_3 are located in the first signal zone (70a), the second signal zone (70b), the third signal zone (70c), and the fourth signal zone (70d) in a one-to-one correspondence; for four third transmission structures in the logic chip (50), a third transmission structure_0, a third transmission structure_1, a third transmission structure_2, and a third transmission structure_3 are located in the first signal zone (70a), the second signal zone (70b), the third signal zone (70c), and the fourth signal zone (70d) in a one-to-one correspondence;
the third transmission structure _3 of the logic chip (50), the first transmission structure_0 of the first memory chip (11), the first transmission structure_1 of the second memory chip (12), the first transmission structure_2 of the third memory chip (13), and the first transmission structure_3 of the fourth memory chip (14) are aligned along the third direction and connected to form a signal transmission channel;
the third transmission structure_2 of the logic chip (50), the first transmission structure_1 of the first memory chip (11), the first transmission structure_0 of the second memory chip (12), the first transmission structure_3 of the third memory chip (13), and the first transmission structure_2 of the fourth memory chip (14) are aligned along the third direction and connected to form a signal transmission channel;
the third transmission structure_1 of the logic chip (50), the first transmission structure_2 of the first memory chip (11), the first transmission structure_3 of the second memory chip (12), the first transmission structure_0 of the third memory chip (13), and the first transmission structure_1 of the fourth memory chip (14) are aligned along the third direction and connected to form a signal transmission channel;
the third transmission structure_0 of the logic chip (50), the first transmission structure_3 of the first memory chip (11), the first transmission structure_2 of the second memory chip (12), the first transmission structure_1 of the third memory chip (13), and the first transmission structure_0 of the fourth memory chip (14) are aligned along the third direction and connected to form a signal transmission channel;
wherein each one of the memory chips (10) obtains a 0^{th}-bit first identification signal from the first transmission structure _0, each one of the memory chips (10) obtains a first-bit first identification signal from the first transmission structure_1, each one of the memory chips (10) obtains a second-bit first identification signal from the first transmission structure_2, and each one of the memory chips (10) obtains a third-bit first identification signal from the first transmission structure _3.

18. The chip stack structure (70) according to claim 17, wherein in a case that B = 2, for two second transmission structure groups in each one of the memory chips (10), a first one of the second transmission structure groups comprises a second transmission structure_0 to a second transmission structure_3, and a second one of the second transmission structure groups comprises a second transmission structure_4 to a second transmission structure_7, wherein the second transmission structure_0 and the second transmission structure _4 are located in the first signal zone (70a), the second transmission structure_1 and the second transmission structure_5 are located in the second signal zone (70b), the second transmission structure_2 and the second transmission structure _6 are located in the third signal zone (70c), and the second transmission structure_3 and the second transmission structure_7 are located in the fourth signal zone (70d); for the logic chip (50), a first one of the fourth transmission structure groups comprises a fourth transmission structure_0 to a fourth transmission structure_3, and a second one of the fourth transmission structure groups comprises a fourth transmission structure_4 to a fourth transmission structure_7, wherein the fourth transmission structure _0 and the fourth transmission structure_4 are located in the first signal zone (70a), the fourth transmission structure_1 and the fourth transmission structure_5 are located in the second signal zone (70b), the fourth transmission structure_2 and the fourth transmission structure _6 are located in the third signal zone (70c), and the fourth transmission structure_3 and the fourth transmission structure_7 are located in the fourth signal zone (70d);
the fourth transmission structure _3 of the logic chip (50), the second transmission structure _0 of the first memory chip (11), the second transmission structure_1 of the second memory chip (12), the second transmission structure_2 of the third memory chip (13), and the second transmission structure_3 of the fourth memory chip (14) are aligned along the third direction and connected to form a signal transmission channel;
the fourth transmission structure_2 of the logic chip (50), the second transmission structure_1 of the first memory chip (11), the second transmission structure_0 of the second memory chip (12), the second transmission structure_3 of the third memory chip (13), and the second transmission structure_2 of the fourth memory chip (14) are aligned along the third direction and connected to form a signal transmission channel;
the fourth transmission structure _1 of the logic chip (50), the second transmission structure2 of the first memory chip (11), the second transmission structure_3 of the second memory chip (12), the second transmission structure_0 of the third memory chip (13), and the second transmission structure_1 of the fourth memory chip (14) are aligned along the third direction and connected to form a signal transmission channel;
the fourth transmission structure_0 of the logic chip (50), the second transmission structure_3 of the first memory chip (11), the second transmission structure_2 of the second memory chip (12), the second transmission structure_1 of the third memory chip (13), and the second transmission structure_0 of the fourth memory chip (14) are aligned along the third direction and connected to form a signal transmission channel;
the fourth transmission structure_7 of the logic chip (50), the second transmission structure_4 of the first memory chip (11), the second transmission structure_5 of the second memory chip (12), the second transmission structure_6 of the third memory chip (13), and the second transmission structure_7 of the fourth memory chip (14) are aligned along the third direction and connected to form a signal transmission channel;
the fourth transmission structure_6 of the logic chip (50), the second transmission structure _5 of the first memory chip (11), the second transmission structure_4 of the second memory chip (12), the second transmission structure_7 of the third memory chip (13), and the second transmission structure_6 of the fourth memory chip (14) are aligned along the third direction and connected to form a signal transmission channel;
the fourth transmission structure_5 of the logic chip (50), the second transmission structure _6 of the first memory chip (11), the second transmission structure_7 of the second memory chip (12), the second transmission structure_4 of the third memory chip (13), and the second transmission structure_5 of the fourth memory chip (14) are aligned along the third direction and connected to form a signal transmission channel;
the fourth transmission structure_4 of the logic chip (50), the second transmission structure _7 of the first memory chip (11), the second transmission structure_6 of the second memory chip (12), the second transmission structure_5 of the third memory chip (13), and the second transmission structure_4 of the fourth memory chip (14) are aligned along the third direction and connected to form a signal transmission channel.

19. The chip stack structure (70) according to claim 15, wherein a top surface of the logic chip (50) or each one of the memory chips (10) is divided into 2×2 signal zones; a first signal zone (70a) and a second signal zone (70b) are arranged symmetrically along a first axis thereof, the first signal zone (70a) and a fourth signal zone (70d) are arranged symmetrically along a second axis thereof, a third signal zone (70c) and the fourth signal zone (70d) are arranged symmetrically along a first axis thereof; the first axes of the logic chip (50) and each one of the memory chips (10) are aligned along the third direction, and the second axes of the logic chip (50) and each one of the memory chips (10) are aligned along the third direction;
in a case that the logic chip (50) and the first memory chip (11) are stacked in a back-to-back manner, the second signal zone (70b) of the logic chip (50), the first signal zone (70a) of the first memory chip (11), the second signal zone (70b) of the second memory chip (12), the third signal zone (70c) of the third memory chip (13), and the fourth signal zone (70d) of the fourth memory chip (14) are aligned along the third direction;
the first signal zone (70a) of the logic chip (50), the second signal zone (70b) of the first memory chip (11), the first signal zone (70a) of the second memory chip (12), the fourth signal zone (70d) of the third memory chip (13), and the third signal zone (70c) of the fourth memory chip (14) are aligned along the third direction;
the fourth signal zone (70d) of the logic chip (50), the third signal zone (70c) of the first memory chip (11), the fourth signal zone (70d) of the second memory chip (12), the first signal zone (70a) of the third memory chip (13), and the second signal zone (70b) of the fourth memory chip (14) are aligned along the third direction;
the third signal zone (70c) of the logic chip (50), the fourth signal zone (70d) of the first memory chip (11), the third signal zone (70c) of the second memory chip (12), the second signal zone (70b) of the third memory chip (13), and the first signal zone (70a) of the fourth memory chip (14) are aligned along the third direction.

20. The chip stack structure (70) according to claim 19, wherein for four first transmission structures in each one of the memory chips (10), a first transmission structure_0, a first transmission structure_1, a first transmission structure_2, and a first transmission structure_3 are located in the first signal zone (70a), the second signal zone (70b), the third signal zone (70c), and the fourth signal zone (70d) in a one-to-one correspondence; for four third transmission structures in the logic chip (50), a third transmission structure_0, a third transmission structure_1, a third transmission structure_2, and a third transmission structure_3 are located in the first signal zone (70a), the second signal zone (70b), the third signal zone (70c), and the fourth signal zone (70d) in a one-to-one correspondence;
the third transmission structure_1 of the logic chip (50), the first transmission structure_0 of the first memory chip (11), the first transmission structure _1 of the second memory chip (12), the first transmission structure_2 of the third memory chip (13), and the first transmission structure_3 of the fourth memory chip (14) are aligned along the third direction and connected to form a signal transmission channel;
the third transmission structure_0 of the logic chip (50), the first transmission structure_1 of the first memory chip (11), the first transmission structure_0 of the second memory chip (12), the first transmission structure_3 of the third memory chip (13), and the first transmission structure_2 of the fourth memory chip (14) are aligned along the third direction and connected to form a signal transmission channel;
the third transmission structure _3 of the logic chip (50), the first transmission structure_2 of the first memory chip (11), the first transmission structure_3 of the second memory chip (12), the first transmission structure_0 of the third memory chip (13), and the first transmission structure_1 of the fourth memory chip (14) are aligned along the third direction and connected to form a signal transmission channel;
the third transmission structure_2 of the logic chip (50), the first transmission structure_3 of the first memory chip (11), the first transmission structure_2 of the second memory chip (12), the first transmission structure_1 of the third memory chip (13), and the first transmission structure_0 of the fourth memory chip (14) are aligned along the third direction and connected to form a signal transmission channel;
wherein each one of the memory chips (10) obtains a 0^{th}-bit first identification signal from the first transmission structure _0, each one of the memory chips (10) obtains a first-bit first identification signal from the first transmission structure_1, each one of the memory chips (10) obtains a second-bit first identification signal from the first transmission structure_2, and each one of the memory chips (10) obtains a third-bit first identification signal from the first transmission structure _3.

21. The chip stack structure (70) according to claim 19, wherein in a case that B = 2, for two second transmission structure groups in each one of the memory chips (10), a first one of the second transmission structure groups comprises a second transmission structure_0 to a second transmission structure_3, and a second one of the second transmission structure groups comprises a second transmission structure_4 to a second transmission structure_7, wherein the second transmission structure_0 and the second transmission structure _4 are located in the first signal zone (70a), the second transmission structure_1 and the second transmission structure_5 are located in the second signal zone (70b), the second transmission structure_2 and the second transmission structure _6 are located in the third signal zone (70c), and the second transmission structure_3 and the second transmission structure_7 are located in the fourth signal zone (70d); for the logic chip (50), a first one of the fourth transmission structure groups comprises a fourth transmission structure_0 to a fourth transmission structure_3, and a second one of the fourth transmission structure groups comprises a fourth transmission structure_4 to a fourth transmission structure_7, wherein the fourth transmission structure _0 and the fourth transmission structure_4 are located in the first signal zone (70a), the fourth transmission structure_1 and the fourth transmission structure_5 are located in the second signal zone (70b), the fourth transmission structure_2 and the fourth transmission structure _6 are located in the third signal zone (70c), and the fourth transmission structure_3 and the fourth transmission structure_7 are located in the fourth signal zone (70d);
the fourth transmission structure _1 of the logic chip (50), the second transmission structure_0 of the first memory chip (11), the second transmission structure_1 of the second memory chip (12), the second transmission structure_2 of the third memory chip (13), and the second transmission structure_3 of the fourth memory chip (14) are aligned along the third direction and connected to form a signal transmission channel;
the fourth transmission structure_0 of the logic chip (50), the second transmission structure _1 of the first memory chip (11), the second transmission structure_0 of the second memory chip (12), the second transmission structure_3 of the third memory chip (13), and the second transmission structure_2 of the fourth memory chip (14) are aligned along the third direction and connected to form a signal transmission channel;
the fourth transmission structure_3 of the logic chip (50), the second transmission structure_2 of the first memory chip (11), the second transmission structure_3 of the second memory chip (12), the second transmission structure_0 of the third memory chip (13), and the second transmission structure_1 of the fourth memory chip (14) are aligned along the third direction and connected to form a signal transmission channel;
the fourth transmission structure_2 of the logic chip (50), the second transmission structure_3 of the first memory chip (11), the second transmission structure_2 of the second memory chip (12), the second transmission structure_1 of the third memory chip (13), and the second transmission structure_0 of the fourth memory chip (14) are aligned along the third direction and connected to form a signal transmission channel;
the fourth transmission structure_5 of the logic chip (50), the second transmission structure_4 of the first memory chip (11), the second transmission structure_5 of the second memory chip (12), the second transmission structure_6 of the third memory chip (13), and the second transmission structure_7 of the fourth memory chip (14) are aligned along the third direction and connected to form a signal transmission channel;
the fourth transmission structure_4 of the logic chip (50), the second transmission structure_5 of the first memory chip (11), the second transmission structure_4 of the second memory chip (12), the second transmission structure_7 of the third memory chip (13), and the second transmission structure_6 of the fourth memory chip (14) are aligned along the third direction and connected to form a signal transmission channel;
the fourth transmission structure_7 of the logic chip (50), the second transmission structure_6 of the first memory chip (11), the second transmission structure_7 of the second memory chip (12), the second transmission structure_4 of the third memory chip (13), and the second transmission structure_5 of the fourth memory chip (14) are aligned along the third direction and connected to form a signal transmission channel;
the fourth transmission structure_6 of the logic chip (50), the second transmission structure_7 of the first memory chip (11), the second transmission structure_6 of the second memory chip (12), the second transmission structure_5 of the third memory chip (13), and the second transmission structure_4 of the fourth memory chip (14) are aligned along the third direction and connected to form a signal transmission channel.

22. The chip stack structure (70) according to any one of claims 15 to 21, wherein
for two chips connected in a face-to-face manner, the transmission structures aligned along the third direction in the two chips are electrically connected through a hybrid bonding process; for two chips connected in a back-to-back manner and for two chips connected in a back-to-face manner, the transmission structures aligned along the third direction in the two chips are electrically connected through a bumping process; or
for two chips connected in a face-to-face manner, for two chips connected in a back-to-back manner,
and for two chips connected in a back-to-face manner, the transmission structures aligned along the third direction in the two chips are electrically connected by a hybrid bonding process; or
for two chips connected in a face-to-face manner, for two chips connected in a back-to-back manner, and for two chips connected in a back-to-face manner, the transmission structures aligned along the third direction in the two chips are electrically connected by a bumping process.

23. A memory (80), comprising the chip stack structure (70) according to any one of claims 15 to 22.
